(19) Europäisches Patentamt
European Patent Office
Office européen des brevets

(11) EP 1 936 714 A1

(12) **EUROPEAN PATENT APPLICATION**
published in accordance with Art. 153(4) EPC

(43) Date of publication:
**25.06.2008 Bulletin 2008/26**

(21) Application number: **06810473.6**

(22) Date of filing: **25.09.2006**

(51) Int Cl.:
***H01L 51/50*** *(2006.01)* ***C09K 11/06*** *(2006.01)*
***G02F 1/13357*** *(2006.01)*

(86) International application number:
**PCT/JP2006/318905**

(87) International publication number:
**WO 2007/043321 (19.04.2007 Gazette 2007/16)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **11.10.2005 JP 2005296235**

(71) Applicant: **KONICA MINOLTA HOLDINGS, INC.**
**Tokyo 100-0005 (JP)**

(72) Inventors:
- **NAKAYAMA, Tomoyuki**
  **Tokyo 191-8511 (JP)**
- **KATOH, Eisaku**
  **Tokyo 191-8511 (JP)**

(74) Representative: **McCluskie, Gail Wilson**
**J.A. Kemp & Co.**
**14 South Square**
**Gray's Inn**
**London WC1R 5JJ (GB)**

(54) **ORGANIC ELECTROLUMINESCENT DEVICE, LIQUID CRYSTAL DISPLAY AND ILLUMINATING DEVICE**

(57) Disclosed is an organic electroluminescent device having excellent power efficiency wherein white balance can be easily controlled. Also disclosed are a liquid crystal display and an illuminating device respectively using such an organic electroluminescent device. Specifically disclosed is an organic electroluminescent device having three or more light-emitting layers of different emission wavelengths, while containing a phosphorescent dopant having an emission maximum wavelength of 440-490 nm in a solid state in at least one of the light-emitting layers. This organic electroluminescent device is characterized in that the ionization potential energy of the phosphorescent dopant is lower than 5.1 eV and than the ionization potential energy of at least one other light-emitting dopant.

EP 1 936 714 A1

## Description

### TECHNICAL FIELD

The present invention relates to an electroluminescent element, a liquid crystal display and an illuminating device.

### TECHNICAL BACKGROUND

Electroluminescent displays are used as light emitting type electronic display device (ELD). As the constituting element of the ELD, an inorganic electroluminescent element (inorganic EL element) and an organic electroluminescent element (organic EL element) are cited. The inorganic EL element has been used as a planar light source though high alternative voltage is required for driving such the light emitting device.

The organic EL element is an element having a light emission layer placed between a cathode and an anode, in which electrons and positive holes are injected into the light emission layer and excitons are generated by recombination of them, and light (fluorescence or phosphorescence) is emitted on the occasion of quenching of the excitons. Such the device is noted because which can emit light by application of a voltage of several to several tens volts, and has wide viewing angle and high visibility since it is a self light emission type, and is completely solid state thin device suitable for space saving and portable appliance.

It is important character of the organic EL element that the element is a planar light source different from ordinary practically used principal light sources such as light emission diodes and cold cathode ray tubes. As the use for effectively utilizing such the character, illuminating light source and backlight for various displays are cited. Particularly, such the element is suitably used for the backlight of liquid crystal full color display which is strongly demanded in recent years.

When the element is used as the backlight of the full color display, the element is used as a source of white light. The following methods are applicable for obtaining white light by the organic EL element; a method in which plural light emission materials are used in an element so as to emit white light by color mixing, a method in which plural colors pixels such as pixels of blue, green and red are separately coated and simultaneously lighted for obtaining white light, and a method in which a color conversion dye such a combination of a blue light emission material and a color conversion fluorescent dye is used for obtaining white light.

The method in which the color emission materials are prepared as one element for obtaining white light is advantageous for the use of backlight from the viewpoint of the requirement for the backlight such as low cost, high production efficiency and simple driving method.

Such the method includes in detail a method using complementary two color materials such as a blue light emission material and a yellow color emission material in one device to obtain by color mixing and that using three color materials to obtain white light by color mixing. However, the method using three colors, blue, green and red, light emission materials is preferable from the viewpoint of color reproducibility and reducing light loss by color filter.

It has been reported that a white light emission organic EL element can be obtained by doping the fluorescent materials reach emits blue, green or red light with high efficiency as the light emission material; cf. Patent Documents 1 and 2 for example.

Moreover, development of phosphorescent light emission material is made progress since an element showing high luminance light emission can be obtained; cf. Non-Patent Documents 1 to 3 for example. Such the effect causes that the light emission efficiency of the phosphorescent light emission material can be raised for 4 times in maximum of that of the fluorescent light emission material because the upper limit of internal quantum efficiency becomes 100% by the later-mentioned formation ratio of the singlet to triplet exciton and the internal conversion from the singlet exciton to the triplet exciton compared with the case of the light emission in usual fluorescent material in which the light is generated from singlet excited state and the formation probability of the light emission exciton species is 25% since the formation ratio of the singlet exciton to triplet exciton is 1:3.

As the organic layer constitution for obtaining white light by color mixing by using plural light emission materials different from each other in the color of the emitting light, a method using one layer in which plural materials different from each other in the emitting light are in a mixture state, and a method by forming layers each composed of the light emission materials different from each other in the emitting light color and preparing an element having multi-layered structure are known. The method by forming the layers each different in the light emission material is preferable because instability of luminance and chromatics caused by transfer of exciting energy between the light emission materials can be reduced.

In such the case, the piling order of the light emission layers is not specifically limited. However, it is described in Non-Patent Document 3 that the light emission efficiency is lowered and the white balance is difficultly controlled when the light emission layer containing the dopant emitting longer wavelength light is arranged on the anode side because the longer wavelength light emitting dopant functions as a strong positive hole capturing center. Besides, when the

shorter wavelength light emission dopant is arranged on the anode sided, the light emission efficiency at the shorter wavelength side is lowered and the white balance is difficultly controlled because the positive hole capturing ability is weak since the ionization potential energy of such the light emission dopant is generally high. Consequently, it has been tried that a positive hole blocking layer adjacent on the cathode side of the shorter wavelength light emission layer arranged on the anode side is provided between the other longer wavelength light emission layer; cf. Non-Patent Document 3 for example. In such the case the light emission efficiency of each of the layers is improved and white balance can be easily controlled. However, problems are caused such as that the driving voltage is raised by the presence of the positive hole blocking layer and the electric power efficiency is lowered.

Patent Document 1: JP A H06-207170
Patent Document 2: JP A 2004-235168
Patent Document 3: U. S. P. No. 6,097,147
Non-Patent Document 1: M. A. Baldo et al., Nature, 395, 151-154 (1998)
Non-Patent Document 2: M. A. Baldo et al., Nature, 403, 750-753 (2000)
Non-Patent Document 3: B. W. D'andrade et al. Advanced Materials, 14, 147-151 (2002)

## DISCLOSURE OF THE INVENTION

## PROBLEMS TO BE SOLVED

An object of the invention is to provide an organic electroluminescent element excellent in the electric power efficiency and easiness in the white balance control, a liquid crystal display and an illuminating element using the electroluminescent element.

## MEANS FOR SOLVING THE PROBLEM

The above object of the invention is attained by the following constitution.

1. An electroluminescent element having three or more light emission layers each containing a dopant and emitting a light having a different wave length from each other in which at least one layer contains a phosphorescent dopant which emits a light having an emission maximum wavelength of from 440 to 490 nm in a solid state, wherein tan ionization potential energy of the phosphorescent dopant is not higher than 5.1 eV and is lower than that of at least one of other light emission dopants.
2. The organic electroluminescent element described in 1, wherein the phosphorescent dopant emitting a light having the emission maximum wavelength of from 440 to 490 nm has a partial structure selected from the following Formulas A to C,

Formula A

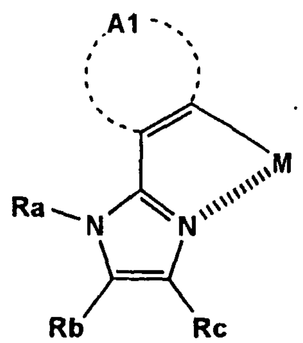

in the formula, Ra is a hydrogen atom, an aliphatic group, an aromatic group or a heterocyclic group, Rb and Rc are each a hydrogen atom or a substituent, A1 is a residue necessary for forming an aromatic group or a heterocyclic group and M is Ir or Pt,

Formula B

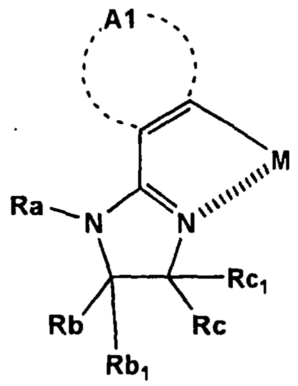

in the above formula, In the above, Ra is a hydrogen atom, an aliphatic group, an aromatic group or a heterocyclic group, Rb, Rc, $Rb_1$ and $Rc_1$ are each a hydrogen atom or a substituent, A1 is a residue necessary for forming an aromatic group or a heterocyclic group and M is Ir or Pt,

Formula C

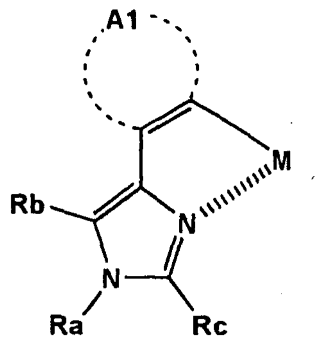

in the formula, Ra is a hydrogen atom, an aliphatic group, an aromatic group or a heterocyclic group, Rb and Rc are each a hydrogen atom or a substituent, A1 is a residue necessary for forming an aromatic group or a heterocyclic group and M is Ir or Pt.

3. A liquid crystal display which has the organic electroluminescent element described in 1 or 2 as a backlight.

4. An illuminating device which has the organic electroluminescent element described in 1 or 2 as a light source.

## EFFECT OF THE INVENTION

The organic electroluminescent element excellent in the electric efficiency and easiness in the white balance control, the liquid crystal display and the illuminating device using the electroluminescent element can be provided by the invention.

## BRIEF DESCRIPTION OF THE DRAWINGS

Fig. 1 shows a schematic drawing of the illuminating device of the invention.

Fig. 2 shows a cross section of the illuminating device of the invention.

## DESCRIPTION OF THE SYMBOLS

- 101: Organic EL element
- 102: Glass cover
- 105: Cathode
- 106: Organic EL layer
- 107: Glass substrate having transparent electrode
- 108: Nitrogen gas
- 109: Moisture capturing agent

## THE BEST EMBODIMENT FOR EMBODYING THE INVENTION

In the invention, the organic electroluminescent element excellent in the electric efficiency and easiness in the white balance control, the liquid crystal display and the illuminating device using the electroluminescent element can be provided by the constitution described in the above Claims 1 to 4.

The details of the constituting elements relating to the invention are successively described bellow.

<<Light emission and front luminance>>

The color of the light emitted from the organic EL element and the compound relating to the organic EL element is defined by the color obtained by applying the results measured by spectral radiation luminance meter CS-100, manufacture by Konica Minolta Sensing Inc., to CIE coordinate according to Fig. 4.16 on p. 108 of New Edited Coloring Science Handbook, edited by The Color Science Association of Japan, University of Tokyo Press (1985).

The chromaticity of the organic EL element of the invention measured at a front luminance of 1,000 cd/$m^2$ at a viewing field angle of 2° without any light condensing means such as a light condensing sheet is preferably at X=0.33±0.07 and Y=0.33±0.77 in CIE1931 chromaticity coordinates.

The organic EL element is preferably has at least three light emission layers each different from each other in the emitting light wavelength, each of which emits light having the emission maximum wavelength of from 440 to 490 nm, hereinafter referred to as blue region, that of from 500 to 540 nm, hereinafter referred to as green region, and that of from 600 to 640 nm, hereinafter referred to as red region, respectively.

In the invention, it is preferable that the entire spectrum of emitting light of the element using such the light emission layers has the emission maximum wavelength of from 440 to 490 nm, 500 to 540 nm and 600 to 640 nm, respectively. Moreover, it is preferable for the use of the liquid crystal display that the minimum intensity of emitting light between the each of the emission maximum is 60% or less of the emission intensity of the adjacent wavelength region and not more than 45% between the blue region and the green region or the green region and the red region. It is also preferable that the minimum intensity wavelength between the blue region and the green region is within the range of from 470 to 510 nm and between the green region and the red region is within the range of from 570 to 600 nm. When the liquid crystal display is constituted by the organic EL element in combination with a color filter, the spectral transmitting property and the minimum intensity wavelength is preferably controlled so as to satisfy the following relation.

$$\lambda_{BG} - 20\ nm \leq \lambda_1 \leq \lambda_{BG} + 10\ nm$$

$$\lambda_{GR} - 20\ nm \leq \lambda_2 \leq \lambda_{GR} + 10\ nm$$

In the above, $\lambda_1$ is the minimum intensity wavelength between the blue region and the green region, $\lambda_2$ is the minimum intensity wavelength between the green region and the red region, $\lambda_{BG}$ is a wavelength where the product of the transparency of the blue pixel in the region of from 450 to 550 nm and that of the green pixel is made largest and $\lambda_{GR}$ is a wavelength where the product of the transparency of the green pixel in the region of from 450 to 550 nm and that of the red pixel is made largest.

The light emission layer relating to the Organic EL element of the invention is described in detail in the later description of the layer constitution of the organic EL element.

Preferable concrete examples of the layer constitution of the organic EL element of the invention are listed

below, though the invention is not limited to them.

(i) Anode/Light emission layer unit/Electron transfer layer/Cathode
(ii) Anode/Positive hole transfer layer/Light emission layer unit/Electron transfer layer/Cathode
(iii) Anode/Positive hole transfer layer/Light emission layer unit/Positive hole blocking layer/Electron transfer layer/Cathode
(iv) Anode/Positive hole transfer layer/Light emission layer unit/Positive hole blocking layer/Electron transfer layer/Cathode buffer layer/Cathode
(v) Anode/Anode buffer layer/Positive hole transfer layer/Light emission layer unit/Positive hole blocking layer/Electron transfer layer/Cathode buffer layer/Cathode

In the above, the light emission layer unit preferably has at least three light emission layer different from each other in the wavelength of emitting light and non-light emission layers between the each of layers.

<<Light emission layer>>

The light emission layer relating to the invention is a layer in which electrons and positive holes each injected from the electrodes or the electron transfer layer and the positive hole transfer layer, respectively, are recombined to emit light and the portion of light emission may be inside of the layer or the interface of the light emission layer and the adjacent layer.

The light emission layer relating to the invention preferably has at least three light emission layers, namely, the blue light emission layer, the green light emission layer and the red light emission layer each having the emission maximum within the blue region, green and red region, respectively even though the structure of the light emission layer of the invention is not specifically limited as long as the emission maximum wavelength of the emitted light is satisfies the above conditions.

When the number of the light emission layer is four or more, plural layers having the same light emission spectrum or the emission maximum wavelength as another layer may be contained.

In the invention, the layers each having the emission maximum wavelength of from 440 to 490 nm, 500 to 540 nm and 600 to 640 nm are referred to as blue light emission layer, green light emission layer and red light emission layer, respectively.

It is preferable that non-light emission intermediate layers are provided between each of the light emission layers.

In the invention, the principal light emission material contained in the blue light emission layer is a phosphorescent dopant and the light emission materials emitting the other color light are preferably also phosphorescent dopants.

The principal light emission material is a material bearing the majority of emitting light intensity and the light emitted from the principal light emission material is preferably 50% or more of the emitting light from the light emission layer.

The total thickness of the light emission layer is preferably within the range of from 2 to 100 nm and more preferably not more than 30 nm because lower driving voltage can be utilized. In the invention, the total thickness of the light emission layers is a thickness including the non-light emission intermediate layers when the intermediate layers are provided.

The thickness of individual light emission layer is preferably controlled within the range of from 2 to 50 nm and more preferably from 2 to 20 nm. The relation between the thickness of each of the blue, green and red light emission layers is not specifically limited.

An organic EL element having blue, green and red light emission layers is disclosed in the foregoing JP A 2003-282265, but the light emission materials are fluorescent light emission materials and the ionization potential energy of the blue light emission material is outside of the range of the invention. An organic EL element having blue, green and red light emission layers is also disclosed in WO 05/27586 pamphlet, but the light emission materials are fluorescent light emission materials and the ionization potential energy of the blue light emission material is outside the range of the invention.

The light emission layer can be prepared by forming a layer of the later-mentioned light emission dopant and the host compound by known method such as a vacuum deposition method, spin coating method, LB method and ink-jet method.

In the invention, plural light emission materials may be mixed in each of the layers and the phosphorescent light emission dopant and the fluorescent light emission dopant may be used in the same layer as long as the foregoing spectral conditions can be maintained.

In the invention, it is preferable that the light emission layer is preferably constituted by containing the host compound and the light emission dopant (also referred as to light emission dopant compound) so as to emit light from the dopant.

As the host compound to be contained in the light emission layer of the organic EL element, a compound is

preferable which has a phosphorescent quantum efficiency of the fluorescent light emission of less than 0.1 and more preferably less than 0.01. The weight ratio of the host compound in the compounds contained in the light emission layer is preferably not less than 20%.

As the host compound, known host compounds may be used singly or in a combination of plural kinds thereof. The transfer of charge can be controlled by the combination use of the host compounds so as to raise the efficiency of the organic EL element. Moreover, mixing of different emitted light is made possible by the use of plural kinds of light emission material so as that optional color light can be obtained.

The light emission host compound may be a known low molecular weight compound, a polymer compound having a repeating unit or a low molecular compound having a polymerizable group such as a vinyl group and an epoxy group(vapor deposition polymerizable light emission host).

As the known host compound, a compound is preferable which has positive hole transferring ability and electron transferring ability, an ability to prevent shift of emitted light to loner wavelength side and high glass transition point Tg. The glass transition point Tg is a value obtained by the method according to JIS-K-7121 using differential scanning colorimetry (DSC).

As known examples of an emission host, compounds described in the following Documents are preferable: For example, JP-A 2001-257076, JP-A 2002-308855, JP-A 2001-313179, JP-A 2002-319491, JP-A 2001-357977, JP-A 2002-334786, JP-A 2002-8860, JP-A 2002-334787, JP-A 2002-15871, JP-A 2002-334788, JP-A 2002-43056, JP-A 2002-334789, JP-A 2002-75645, JP-A 2002-338579, JP-A 2002-105445, JP-A 2002-343568, JP-A 2002-141173, JP-A 2002-352957, JP-A 2002-203683, JP-A 2002-363227, JP-A 2002-231453, JP-A 2003-3165, JP-A 2002-234888, JP-A 2003-27048, JP-A 2002-255934, JP-A 2002-260861, JP-A 2002-280183, JP-A 2002-299060, JP-A 2002-302516, JP-A 2002-305083, JP-A 2002-305084 and JP-A 2002-308837.

The emission dopant of this invention will now be described.

As an emission dopant used in this invention, a fluorescent compound or a phosphorescence emitting dopant (also referred to as a phosphorescent compound or a phosphorescence emitting compound) are employed.

The phosphorescence emitting material is a compound which emits light from the excited triplet, which is specifically a compound which emits phosphorescence at room temperature (25 °C), and is defined to exhibit a phosphorescent quantum yield at 25 °C of not less than 0.01, and the phosphorescent quantum yield at 25 °C is preferably not less than 0.1.

The phosphorescent quantum yield can be measured according to a method described in the fourth edition "Jikken Kagaku Koza 7", Bunko II, page 398 (1992) published by Maruzen. The phosphorescent quantum yield in a solution can be measured employing various kinds of solvents. The phosphorescence emitting material of the present invention is a compound, in which the phosphorescent quantum yield measured employing any one of the solvents falls within the above-described range (0.01 or more).

The light emission of the phosphorescence emitting material is divided in two types in principle, one is an energy transfer type in which recombination of a carrier occurs on the host to which the carrier is transported to excite the host, the resulting energy is transferred to the phosphorescent compound, and light is emitted from the phosphorescent compound, and the other is a carrier trap type in which recombination of a carrier occurs on the phosphorescent compound which is a carrier trap material, and light is emitted from the phosphorescent compound. However, in each type, energy level of the phosphorescent compound in excited state is lower than that of the host in excited state.

The phosphorescence emitting material can be optionally selected from the known phosphorescence emitting materials used in the light emission layer of an organic EL element.

The phosphorescence emitting material is preferably a complex containing a metal of Group 8 - 10 of the periodic table, and more preferably an iridium compound, an osmium compound, a platinum compound (a platinum complex compound) or a rare-earth metal complex. Of these, most preferable is an iridium compound.

Specific examples of a compound used as a phosphorescence emitting material are shown below, however, the present invention is not limited thereto. These compounds can be synthesized, for example, according to a method described in Inorg. Chem., 40, 1704-1711.

Ir−1

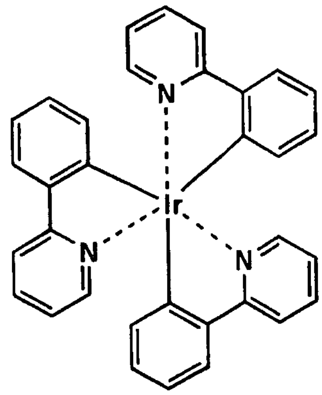

Ir−2

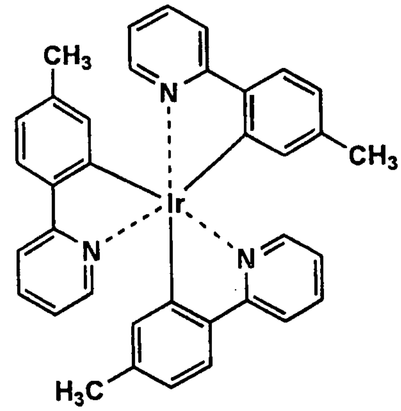

Ir−3

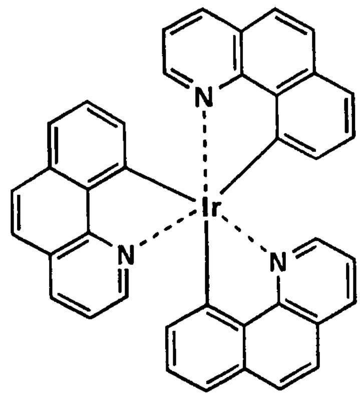

Ir−4

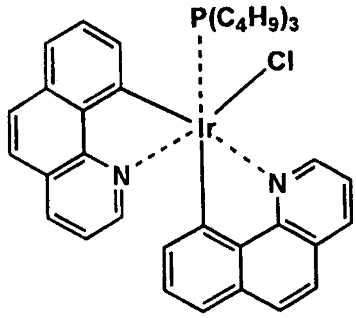

Ir−5

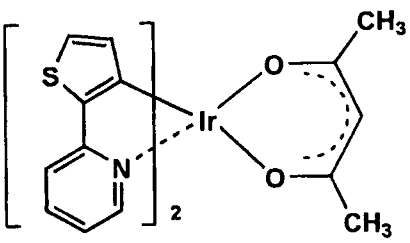

Ir−6

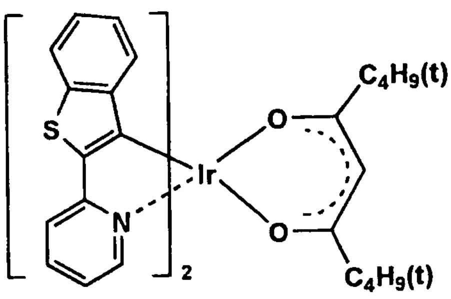

Ir-7

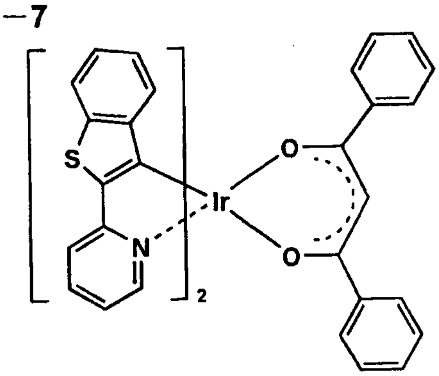

Ir-8

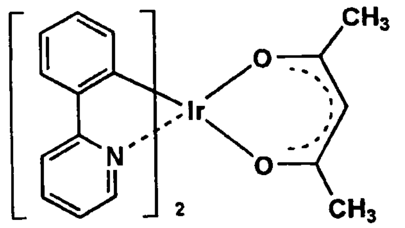

Ir-9

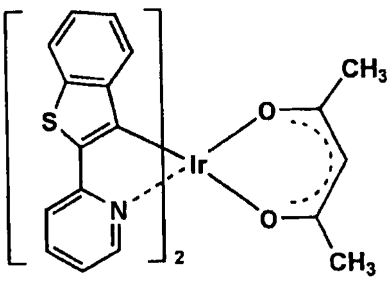

Ir-10

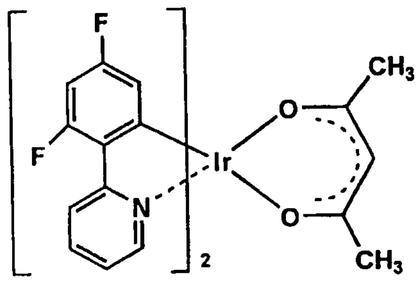

Ir-11

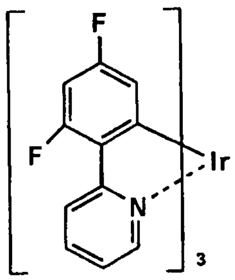

Ir-12

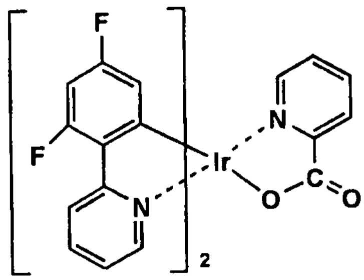

Ir-13

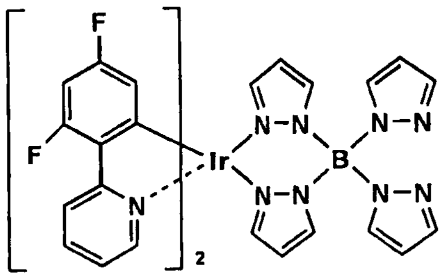

Ir-14

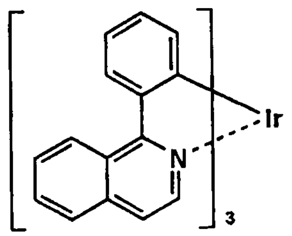

Pt−1

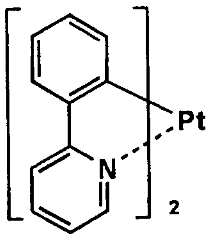

Pt−2

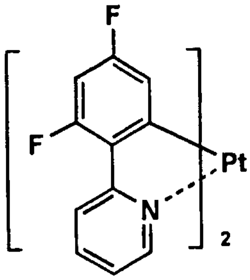

Pt−3

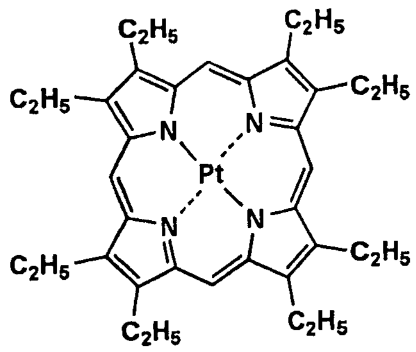

Os−1

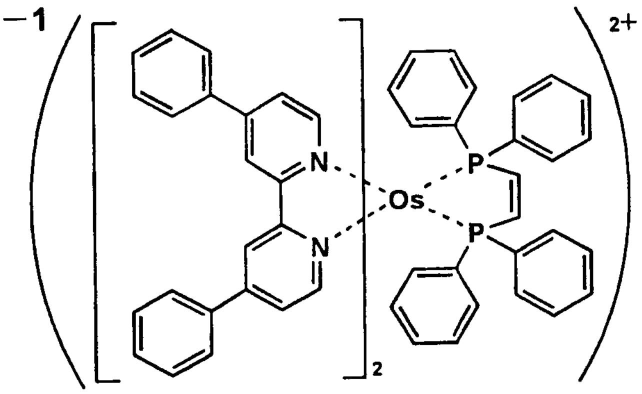

$(CF_3CF_2CF_2COO^-)_2$

E-1

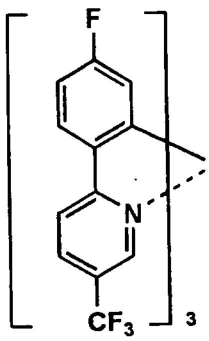

E-2

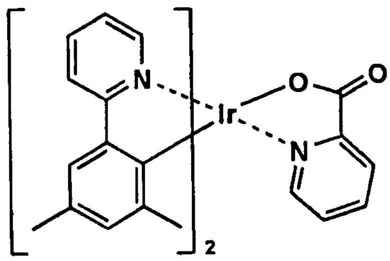

E-3

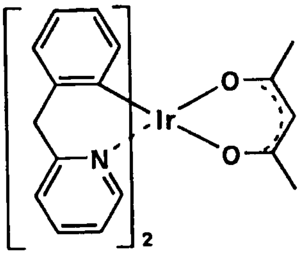

E-4

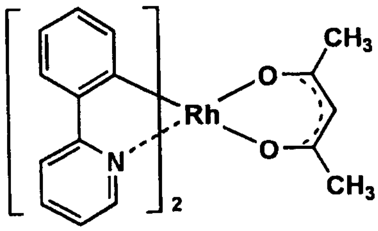

E-5

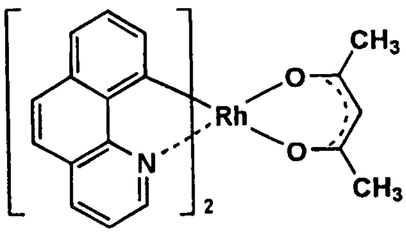

E-6

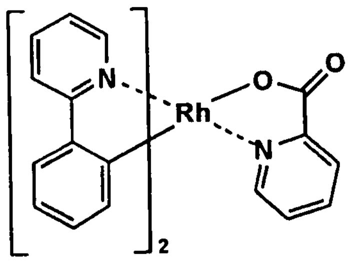

Pd-1

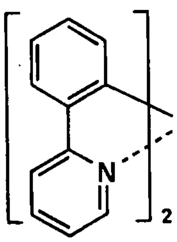

Pd-2

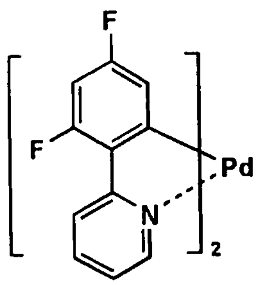

Pd-3

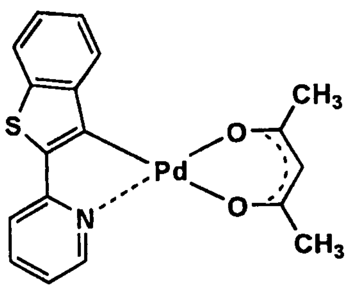

Rh−1

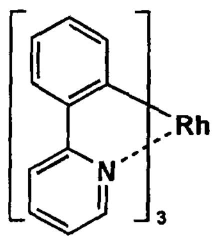

Rh−2

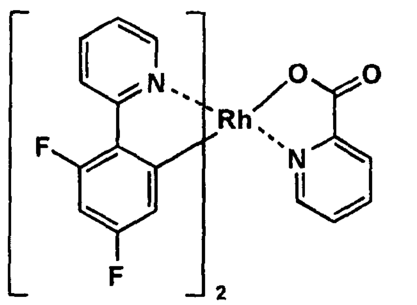

Rh−3

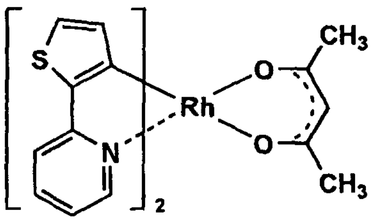

In the invention, a phosphorescent dopant is contained in at least one layer, which has an emission maximum wavelength of from 440 to 490 nm and an ionization potential of not more than 5.1 eV. The ionization potential of the phosphorescent light emission dopant is within the range of from 2.9 to 5.1 eV since the highest occupying level of the phosphorescent dopant is lower than the vacuum level though the lower limit of the ionization potential energy is not specifically limited.

The ionization potential energy of the light emission dopant, particularly the phosphorescent light emission dopant emitting light of 440 to 490 nm, is generally higher than 5.1 eV and any precedent using such the dopant for the white light emitting organic EL element of the invention is not known.

In the invention, the ionization potential energy of the dopant emitting light of 440 to 490 nm has ionization potential energy of 5.1 eV or less and such the ionization potential energy is lower than that of at least one kind of the other light emission dopant. Consequently, the positive hole capturing ability of the blue light emission dopant emitting light of 440 to 490 nm tends to be higher than that of at least one kind of the other kind of dopant arranged on the cathode side even when the blue light emission dopant is provided on the anode side. As a result of that, white light emission with high efficiency is made possible even when no positive hole blocking layer is provided on the cathode side of the blue light emission dopant.

The phosphorescent dopant relating to the invention which is characterized in that the dopant has the emission maximum wavelength of from 440 to 490 nm and an ionization potential energy of not more than 5.1 eV preferably has the partial structure represented by Formula A, B or C.

In Formula A to C, A1 is a residue necessary forming an aromatic ring or an aromatic heterocyclic ring. As the aromatic ring, a benzene ring, a biphenyl ring, a naphthalene ring, an azulene ring, an anthracene ring, a phenanthrene ring, a pyrene ring, a chrysene ring, a naphthacene ring, a triphenylene ring, an o-terphenyl ring, an m-terphenyl ring, a p-terphenyl ring, an acenaphthene ring, a coronene ring, a fluorene ring, a fluoranthrene ring, a naphthacene ring, a pentacene ring, a perylene ring, a pentaphene ring, a picene ring, a pyrene ring, a pyranthrene ring and an anthranthrene ring are cited, and as the aromatic ring, and a furan ring, a thiophene ring, a pyridine ring, pyridazine ring, a pyrimidine ring, a pyrazine ring, a triazine ring, a benzimidazole ring, an oxadiazole ring, a triazole ring, an imidazole ring, a pyrazole ring, a thiazole ring, an indole ring, a benzimidazole ring, a benzothiazole ring, a benzoxazole ring, a quinoxaline ring, a quinazoline ring, a phthalazine ring, a carboline ring and a diazacarbazole ring (a hydrocarbon ring constituting carboline ring in which one carbon atom is replaced by a nitrogen atom) are cited as the aromatic heterocyclic ring.

In Formula A to C, Ra is a hydrogen atom, an aliphatic group, an aromatic group, or a heterocyclic group, and Rb, Rc, $Rb_1$ and $Rc_1$ are each a hydrogen atom or a substituent. As the substituent represented by Rb, Rc, $Rb_1$ or $Rc_1$ include an alkyl group such as a methyl group, an ethyl group, a propyl group, an isopropyl group, a tert-butyl group, a pentyl group, a hexyl group, an octyl group, a dodecyl group, a tridecyl group, a tetradecyl group and a pentadecyl group; a cycloalkyl group such as a cyclopentyl group and a cyclohexyl group; an alkenyl group such as a vinyl group and an allyl group; an alkynyl group such as ethynyl group and a propargyl group; an aryl group such as a phenyl group and a naphthyl group; an aromatic heterocyclic group such as a furyl group, a pyridyl group, a pyridazinyl group, a pyrimidinyl group, a pyrazinyl group, a triazinyl group, an imidazolyl group, a pyrazolyl group, a thiazolyl group, a quinazolinyl group and a phthalazinyl group; a heterocyclic group such as pyrrolidyl group, an imidazolidyl group, a morpholyl group and an oxazolidyl group; an alkoxy group such as a methoxy group, an ethoxy group, a propyloxy group, a pentyloxy group, a hexyloxy group, an octyloxy group and a dodecyloxy group; a cycloalkoxy group such as a cyclopentyloxy group and a cyclohexyloxy group; an aryloxy group such as a phenoxy group and a naphthyloxy group; an alkylthio group such as a methylthio group, an ethylthio group, a propylthio group, a pentylthio group, a hexylthio group, an octylthio group and

a dodecylthio group; a cycloalkylthio group such as a cyclopentylthio group and a cyclohexylthio group; an arylthio group such as a phenylthio group and a naphthylthio group; an alkoxycarbonyl group such as a methyloxycarbonyl group, an ethyloxycarbonyl group, a butyloxycarbonyl group, an octyloxycarbonyl group, and a dodecyloxycarbonyl group; an aryloxycarbonyl group such as a phenyloxycarbonyl group and a naphthyloxycarbonyl group; a sulfamoyl group such as an aminosulfonyl group, a methylaminosulfonyl group, a dimethylaminosulfonyl group, a butylaminosulfonyl group, a hexylaminosulfonyl group, a cyclohexylaminosulfonyl group, an octylaminosulfonyl group, a dodecylaminosulfonyl group, a phenylaminosulfonyl group, a naphthylaminosulfonyl group and a 2-pyridylaminosulfonyl group; an acyl group such as an acetyl group, an ethylcarbonyl group, a propylcarbonyl group, a pentylcarbonyl group, a cyclohexylcarbonyl group, an octylcarbonyl group, a 2-ethylhexylcarbonyl group, a dodecylcarbonyl group, a phenylcarbonyl group, a naphthylcarbonyl group and a pyridylcarbonyl group; an acyloxy group such as an acetyloxy group, an ethylcarbonyloxy group, a butylcarbonyloxy group, an octylcarbonyloxy group, a dodecylcarbonyloxy group and phenylcarbonyloxy group; an amido group such as a methylcarbonylamino group, an ethylcarbonylamino group, a dimethylcarbonylamino group, a propylcarbonylamino group, a pentylcarbonylamino group, a cyclohexylcarbonylamino group, a 2-ethylhexylcarbonylamino group, an octylcarbonylamino group, a dodecylcarbonylamino group, a phenylcarbonylamino group and a naphthylcarbonylamino group; a carbamoyl group such as an aminocarbonyl group, a methylaminocarbonyl group, a dimethylaminocarbonyl group, a propylaminocarbonyl group, a pentylaminocarbonyl group, a cyclohexylaminocarbonyl group, an octylaminocarbonyl group, an ethylhexylaminocarbonyl group, a dodecylaminocarbonyl group, a phenylaminocarbonyl group, a naphthylaminocarbonyl group and a 2-pyridylaminocarbonyl group; a ureido group such as a methylureido group, an ethylureido group, a pentylureido group, a cyclohexylureido group, an octylureido group, a dodecylureido group, a phenylureido group, a naphthylureido group and a 2-pyridylaminoureido group; a sulfinyl group such as a methylsulfinyl group, an ethylsulfinyl group, a butylsulfinyl group, a cyclohexylsulfinyl group, a 2-ethylhexylsulfinyl group, a dodecylsulfinyl group, a phenylsulfinyl group, a naphthylsulfinyl group and a 2-pyridylsulfinyl group; an alkylsulfonyl group such as a methylsulfonyl group, an ethylsulfonyl group, a butylsulfonyl group, a cyclohexylsulfonyl group, a 2-ethylhexylsulfonyl group and a dodecylsulfonyl group; an arylsulfonyl group such as a phenylsulfonyl group, a naphthylsulfonyl group and a 2-pyridylsulfonyl group; an amino group such as an amino group, an ethylamino group, a dimethylamino group, a butylamino group, a cyclopentylamino group, a 2-ethylhexylamino group, a dodecylamino group, an anilino group, a naphthylamino group and a 2-pyridylamino group; a halogen atom such as a fluorine atom, a chlorine atom and a bromine atom; a fluorohydrocarbon group such as a fluoromethyl group, a trifluoromethyl group, a pentafluoroethyl group and pentafluorophenyl group; a cyano group; a nitro group, a hydroxyl group, a mercapto group; and a silyl group such as a trimethylsilyl group, a triisopropylsilyl group, a triphenylsilyl group and a phenyldiethylsilyl group. These substituents are each further substituted by the above substituents.

Formulas A to C are each a partial structure and a ligand corresponding to the valent number of the central metal atom is necessary for completing the phosphorescent light emission dopant. Examples of the concrete ligand include a halogen atom such as a fluorine atom, a chlorine atom, a bromine atom and an iodine atom; an aryl group such as a phenyl group, a p-chlorophenyl group, a mesityl group, a tolyl group, a xylyl group, a biphenyl group, a naphthyl group, an anthryl group and a phenanthryl group; an alkyl group such as a methyl group, an ethyl group, an isopropyl group, a hydroxyethyl group, a methoxymethyl group, a trifluoromethyl group and a t-butyl group; an alkyloxy group; an aryloxy group; an alkylthio group; an arylthio group; an aromatic heterocyclic group such as a furyl group, a thienyl group, a pyridyl group, a pyridazinyl group, a pyrimidinyl group, a pyrazinyl group, a triazinyl group, an imidazolyl group, a pyrazolyl group, a thiazolyl group, a quinazolyl group, a carbazolyl group, a carbolinyl group and a phthalazinyl group; and the partial structure formed by removing the metal part from the structure represented by Formula A, B or C.

In Formulas A to C, M is Ir or Pt and Ir is particularly preferred. A tris-compound formed by three partial structure represented by Formula A, B or C is preferable.

Examples of the phosphorescent light emission dopant relating to the invention which has the partial structure of Formula A, B or C are listed below, though the dopant is not limited to them.

D-1

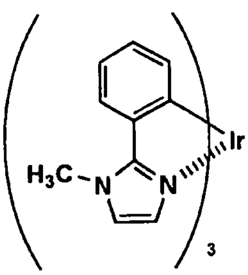

D-2

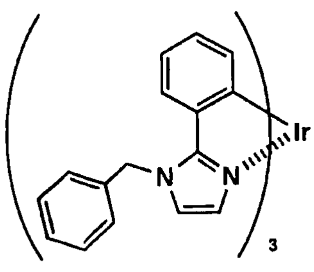

D-3

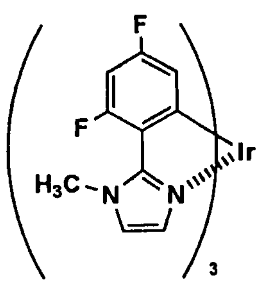

D-4

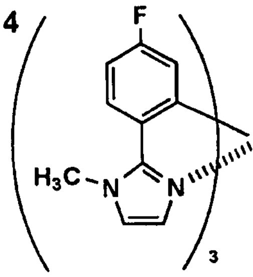

D-5

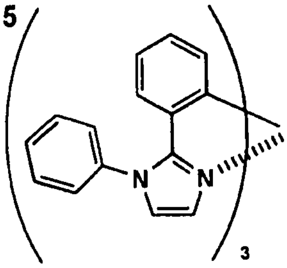

D-6

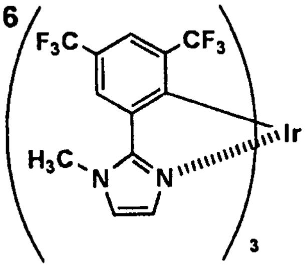

D-7

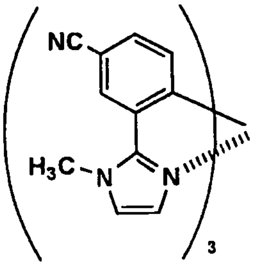

D-8

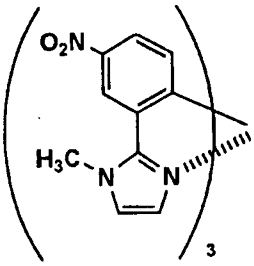

D-9

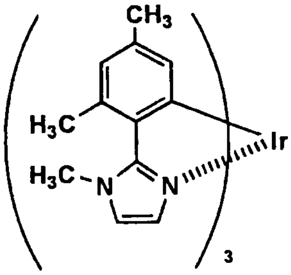

D-10

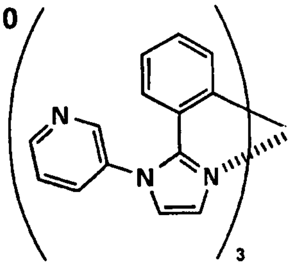

D-11

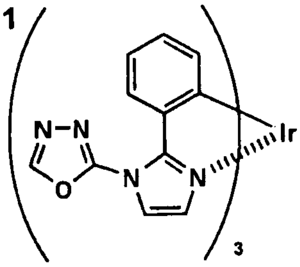

D-12

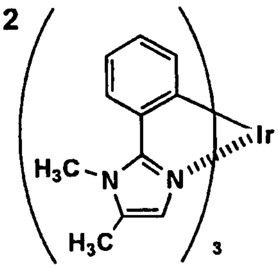

D-13

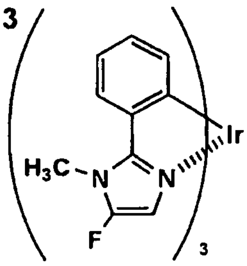

D-14

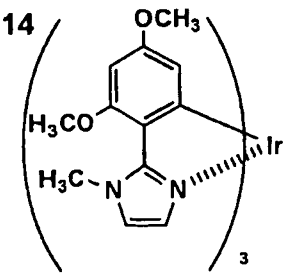

D-15

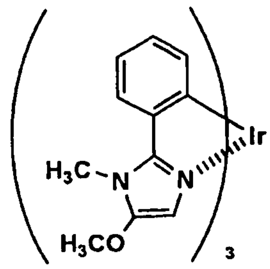

D-16

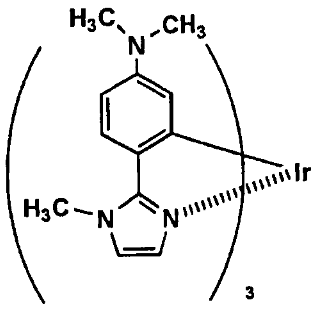

D-17

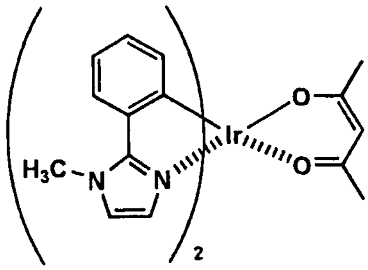

D-18

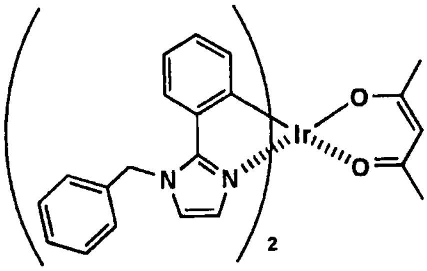

D-19

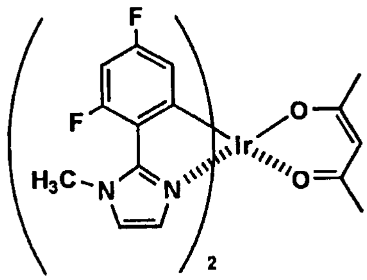

D-20

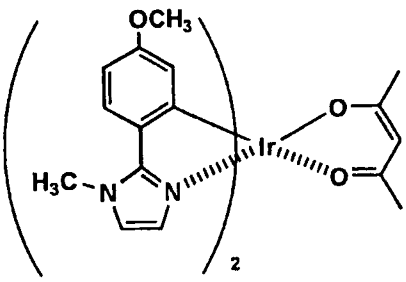

D-21

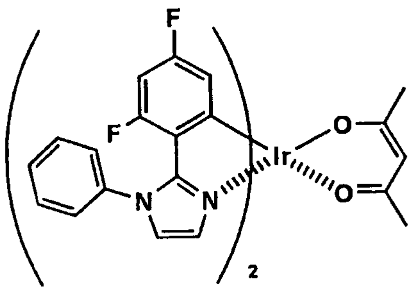

D-22

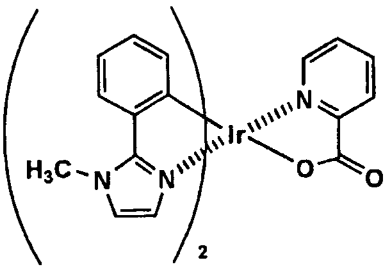

D-23

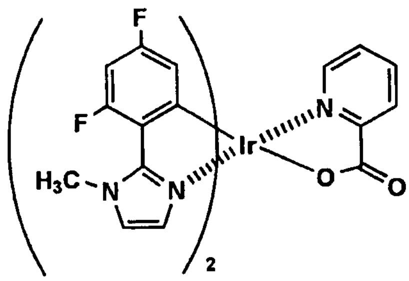

D-24

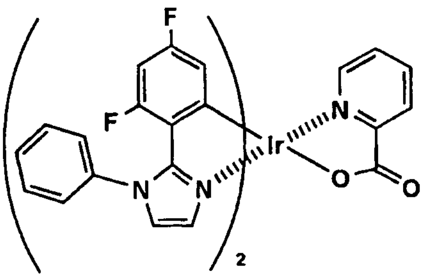

D-25

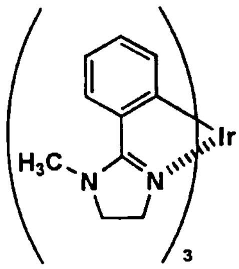

D-26

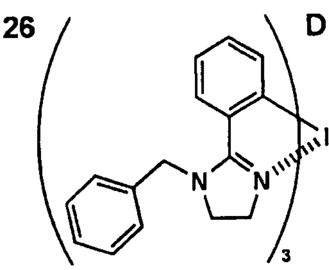

D-27

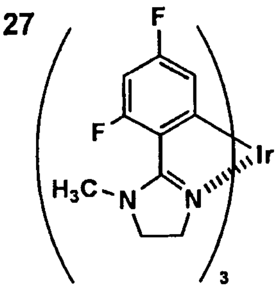

D-28

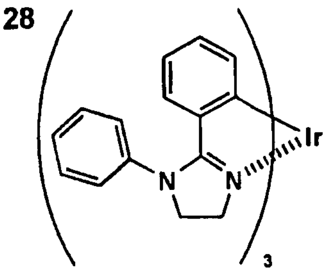

D-29

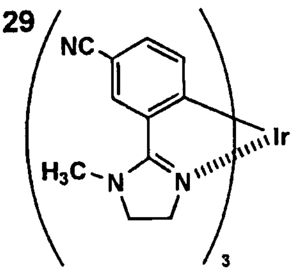

D-30

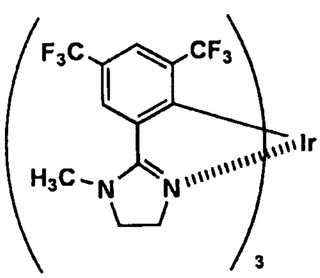

D-31

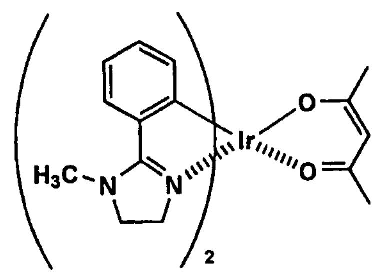

D-32

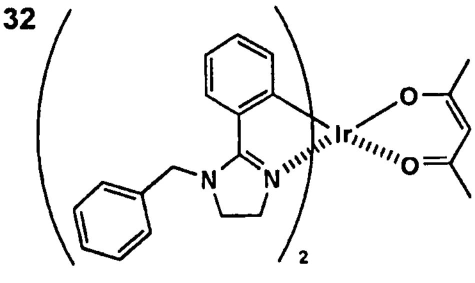

D-33

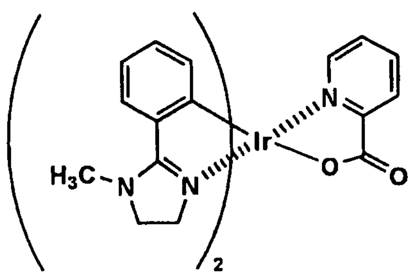

D−34

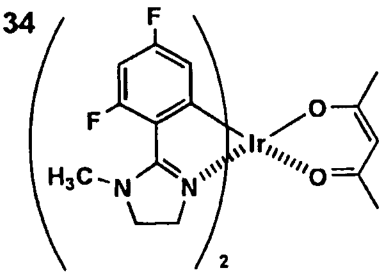

D−35

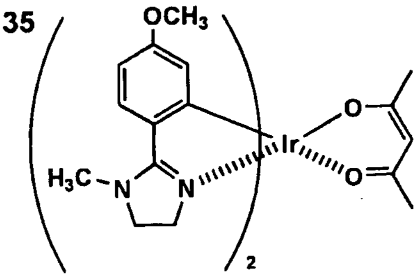

D−36

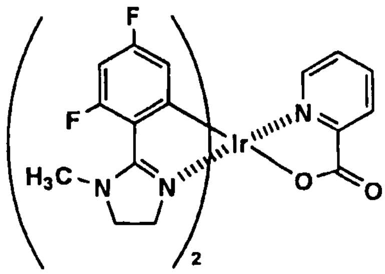

D−37

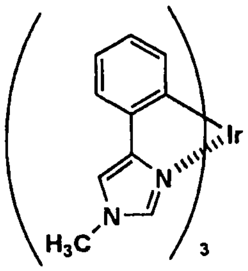

D−38

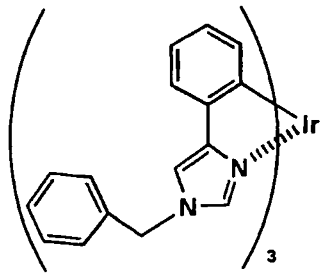

D−39

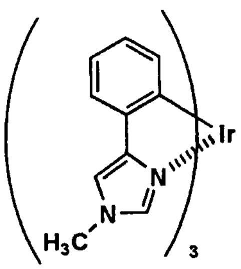

D−40

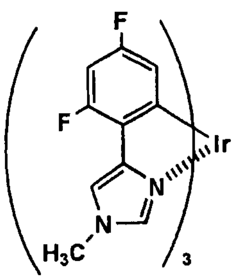

D−41

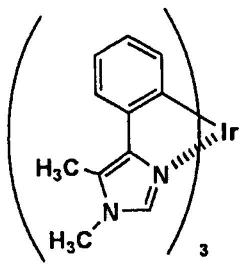

D−42

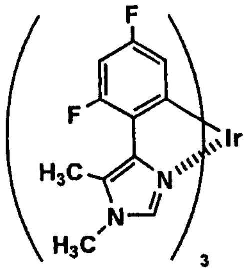

D−43

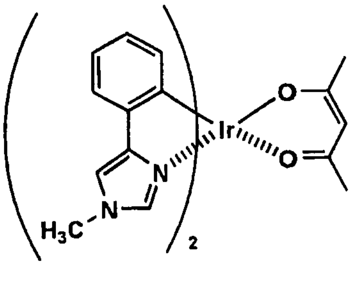

D−44

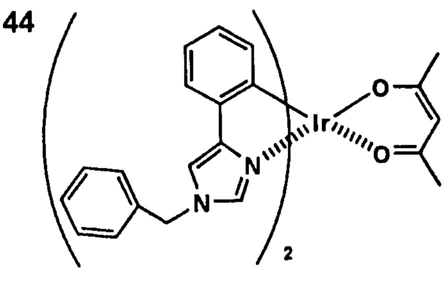

D-45

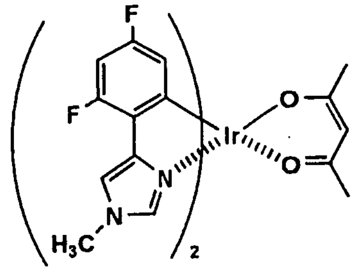

D-46

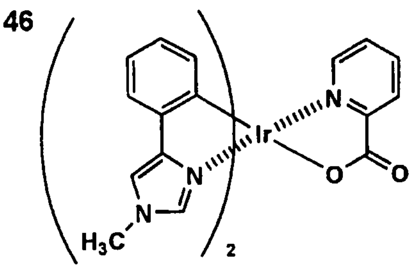

D-47

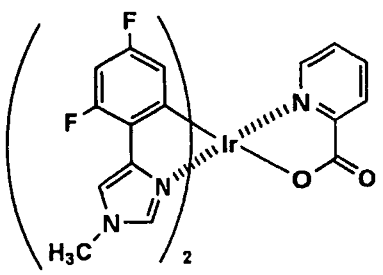

D-48

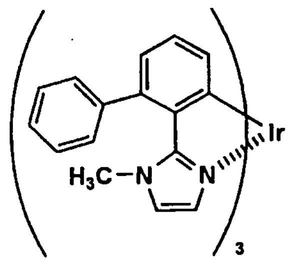

D-49

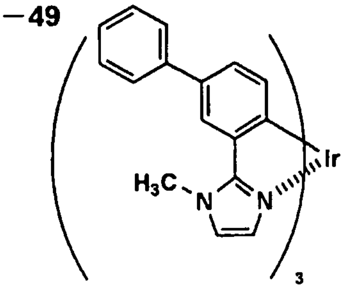

D-50

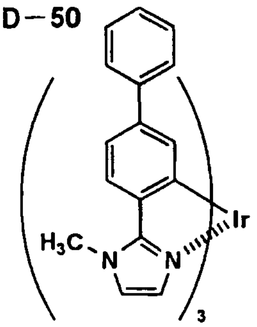

D-51

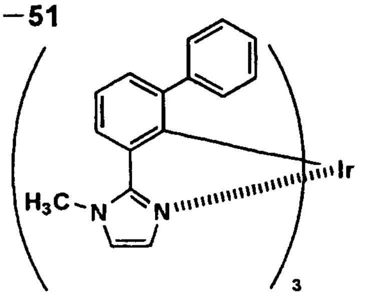

D-52

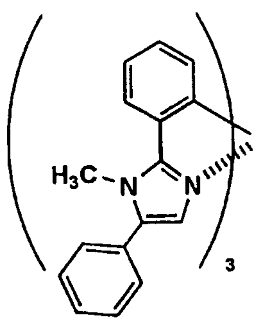

D-53

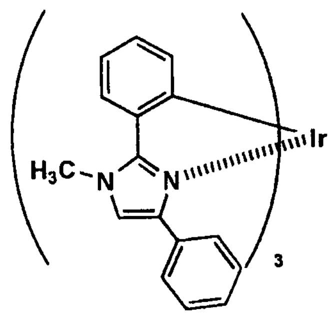

D-54

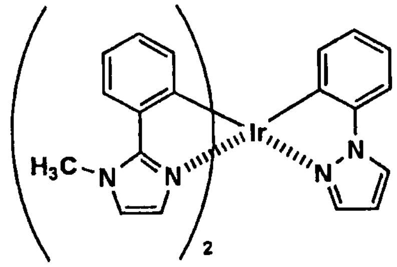

D-55

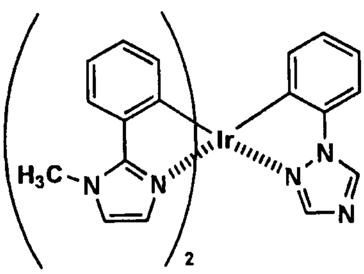

D-56

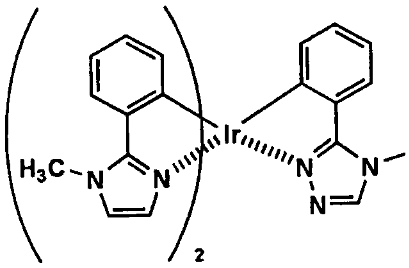

D-57

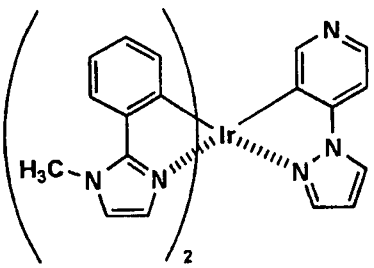

D-58

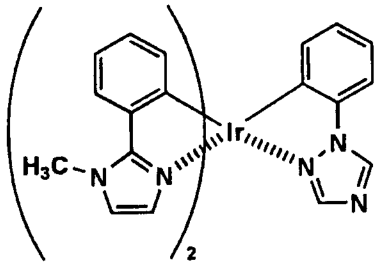

D-59

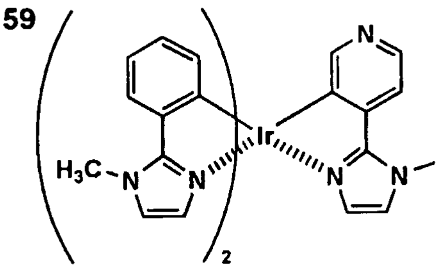

D-60

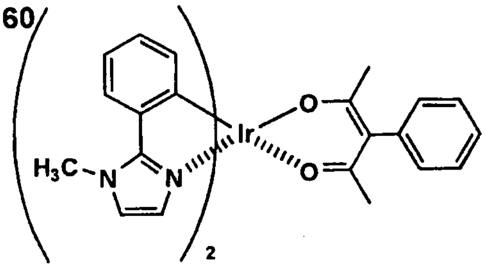

D-61

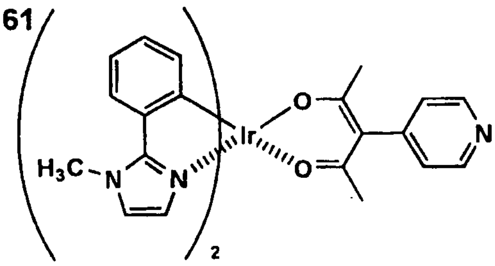

D-62

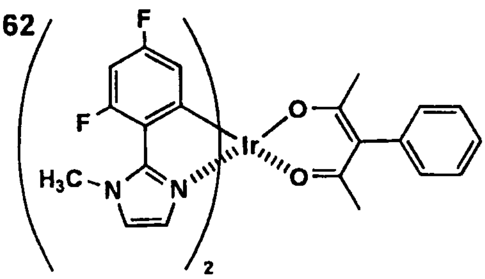

D-63

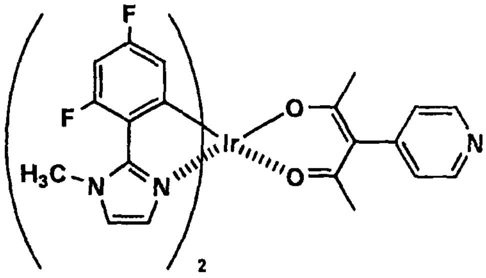

D-64

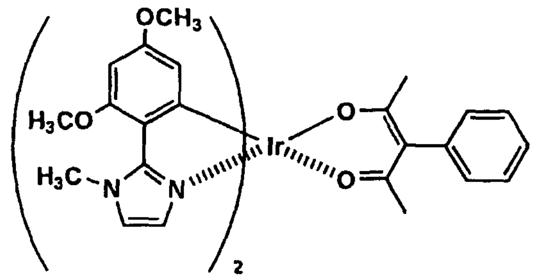

D-65

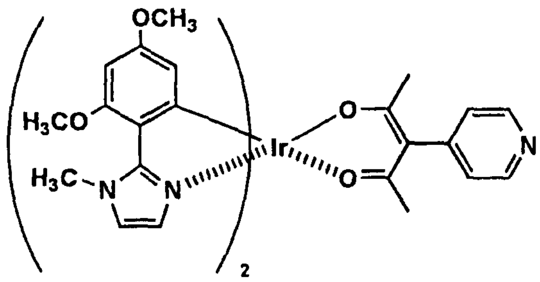

The synthesizing example of the compound having the partial structure represented by Formula A, B or C is described below.

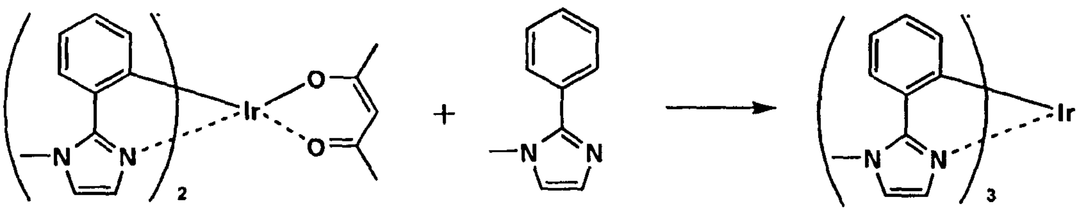

D-1acac D-1

To a three mouthed 500 ml flask, 4.0 g of D-lacac, 2.6 g of phenylimidazole, 300 ml of glycerol were charged and a thermometer and a cooler were attached on the flask, and the flask was set on an oil bath stirrer and then gradually heated. The bath temperature was adjusted so that the interior temperature was held at 150 °C and the reaction system was stirred for 5 hours to complete the reaction. Crystals were precipitated when the system was cooled by room temperature. The reacting liquid was diluted by 200 ml of methanol and the crystals were filtered and sufficiently washed by methanol and 1.6 g (36.5%) of product was obtained. It was confirmed by $^1$H-NMR and MASS that the crystals were D-1.

A typical example of the former (a fluorescent dopant) includes coumarin type dye, pyran type dye, cyanine type dye, croconium type dye, squalium type dye, oxobenzanthracene type dye, fluorescein type dye, rhodamine type dye, pyrilium type dye, perylene type dye, stilbene type dye, polythiophene type dye or rare earth complex type fluorescent substances.

Known dopants may also be employed, examples thereof are listed;

WO 00/70655, JP-A 2002-280178, JP-A 2001-181616, JP-A 2002-280179, JP-A 2001-181617, JP-A 2002-280180, JP-A 2001-247859, JP-A 2002-299060, JP-A 2001-313178, JP-A 2002-302671, JP-A 2001-345183, JP-A 2002-324679,

WO 02/15645, JP-A 2002-332291, JP-A 2002-50484, JP-A 2002-332292, JP-A 2002-83684, JP-A 2002-540572, JP-A 2002-117978, JP-A 2002-338588, JP-A 2002-170684, JP-A 2002-352960, WO 01/93642, JP-A 2002-50483, JP-A 2002-100476, JP-A 2002-173674, JP-A 2002-359082, JP-A 2002-175884, JP-A 2002-363552, JP-A 2002-184582, JP-A 2003-7469, JP-A 2002-525808, JP-A 2003-7471, JP-A 2002-525833, JP-A 2003-31366, JP-A 2002-226495, JP-A 2002-234894, JP-A 2002-235076, JP-A 2002-241751, JP-A 2001-319779, JP-A 2001-319780, JP-A 2002-62824, JP-A 2002-100474, JP-A 2002-203679, JP-A 2002-343572, JP-A 2002-203678 and so on.

The non-light emission intermediate layer (also referred to as non-doped region) to be used in the invention is described bellow.

The non-light emission intermediate layer is a layer provided between the light emission layers when the organic EL element has plural light emission layers. The thickness of the non-light emission intermediate layer is preferably within the range of from 1 to 20 nm, and that being within the range of from 3 to 10 nm is particularly preferable by the reason of that the having such the thickness inhibits the interaction between the adjacent light emission layer such as energy transfer and does not give excessive load on the current-voltage property of the element.

The material to be used in the non-light emission intermediate layer may be the same as or different from the host compound of the light emission layer, and preferably the same as the host compound contained in at least one of the adjacent light emission layers.

The non-light emission intermediate layer may contain a compound such as the host compound in common with the each of the light emission layers, and the injection barrier between the light emission layer and the non-light emission layer is lowered, and the injection of the positive holes and electrons can be easily balanced even when the voltage (or current) is varied by that the commonly presence of the compound in these layers. Here, the common host material means the host materials in the layers are the same in the physicochemical property such as glass transition point or in the molecular structure. Furthermore, the complication of the production process which is a large problem on the production of the organic EL element can be also solved by using the host material in the non-doped light emission layer, which is the same as that used in each of the light emission layers in the physicochemical property or the molecular structure.

In the invention, the host material takes charge of transfer of the carrier; therefore, the host material preferably has carrier transferring ability. As a property for expressing the carrier transferring ability, carrier mobility is usually utilized and the carrier mobility is generally depended on the electric field strength. Material having low dependency on the electric field strength of the carrier mobility is preferably used for the material of the intermediate layer and the host material because the balance of the injection and transfer of the positive holes and the electrons tens to be lost in the material having high electric field strength dependency material.

On the other hand, it can be cites as a preferable embodiment that the non-light emission intermediate layer functions as the later-mentioned blocking layer, namely a positive hole blocking layer or an electron blocking layer, for suitably controlling the injection balance of the positives hole and electrons.

<<Injection Layer: Electron Injection Layer, Positive Hole Injection Layer>>

An injection layer is provided when it is necessary and includes an electron injection layer and a positive hole injection layer, which may be arranged between an anode and an emission layer or a positive transfer layer, and between a cathode and an emission layer or an electron transfer layer, as described above.

An injection layer is a layer which is arranged between an electrode and an organic layer to decrease an driving voltage and to improve an emission luminance, which is detailed in volume 2, chapter 2 (pp. 123 - 166) of "Organic EL Elements and Industrialization Front thereof (Nov. 30th 1998, published by N. T. S. Inc.)", and includes a positive hole injection layer (an anode buffer layer) and an electron injection layer (a cathode buffer layer).

An anode buffer layer (a positive hole injection layer) is also detailed in such as JP-A H09-45479, JP-A H09-260062 and JP-A H08-288069, and specific examples include such as a phthalocyanine buffer layer represented by such as copper phthalocyanine, an oxide buffer layer represented by such as vanadium oxide, an amorphous carbon buffer layer, and a polymer buffer layer employing conductive polymer such as polyaniline (emeraldine) and polythiophene.

A cathode buffer layer (an electron injection layer) is also detailed in such as JP-A H06-325871, JP-A H09-17574 and JP-A H10-74586, and specific examples include a metal buffer layer represented by strontium, aluminum and so on, an alkali metal compound buffer layer represented by lithium fluoride, an alkali metal earth compound buffer layer represented by magnesium fluoride and an oxide buffer layer represented by aluminum oxide. The above-described buffer layer (injection layer) is preferably a very thin layer, and the layer thickness is preferably in a range of 0.1 nm - 5 $\mu m$ although it depends on a raw material.

<Inhibition Layer : Positive Hole Inhibition Layer, Electron Inhibition Layer>

An inhibition layer is provided in addition to an elemental layer arrangement of the organic compound layer as described above. There is, for example, a positive inhibition (hole block) layer described in such as JP-A H11-204258 and JP-A H11-209359 and p.273 of "Organic EL Elements and Industrialization Front Thereof (Nov. 30 (1998), published by NTS. Inc.)".
A positive hole inhibition layer, in a broad meaning, is provided with a function of electron transport layer, being comprised of a material having a function of transporting an electron but a very small ability of transporting a positive hole, and can improve the recombination probability of an electron and a positive hole by inhibiting a positive hole while transporting an electron. Further, an arrangement of an electron transport layer described later can be appropriately utilized as a positive hole inhibition layer according to this invention.
The positive hole inhibition layer of the organic EL element of this invention is preferably provided adjacent to an emission layer.
On the other hand, an electron inhibition layer is, in a broad meaning, provided with a function of a positive hole transport layer, being comprised of a material having a function of transporting a positive hole but a very small ability of transporting an electron, and can improve the recombination probability of an electron and a positive hole by inhibiting an electron while transporting a positive hole. Further, an arrangement of a positive hole transport layer described later can be appropriately utilized as an electron inhibition layer. Thickness of the positive hole inhibition layer and electron transport layer is preferably 3 - 100 nm, and more preferably 5 - 30 nm.

<Positive Hole Transport Layer>

A positive hole transport layer contains a material having a function of transporting a positive hole, and in a broad meaning, a positive hole injection layer and an electron inhibition layer are also included in a positive hole transport layer. A single layer of or plural layers of a positive hole transport layer may be provided.
A positive hole transport material is those having any one of a property to inject or transport a positive hole or a barrier property to an electron, and may be either an organic material or an inorganic material. For example, listed are a triazole derivative, an oxadiazole derivative, an imidazole derivative, a polyarylalkane derivative, a pyrazoline derivative, a pyrazolone derivative, a phenylenediamine derivative, a arylamine derivative, an amino substituted chalcone derivative, an oxazole derivatives, a styrylanthracene derivative, a fluorenone derivative, a hydrazone derivative, a stilbene derivative, a silazane derivative, an aniline type copolymer, or conductive high molecular oligomer, specifically preferably such as thiophene oligomer.
As a positive hole transport material, those described above can be utilized, however, it is preferable to utilize a porphyrin compound, an aromatic tertiary amine compound and a styrylamine compound, and specifically preferably an aromatic tertiary amine compound.
Typical examples of an aromatic tertiary amine compound and a styrylamine compound include N,N,N',N'-tetraphenyl-4,4'-diaminophenyl; N,N'-diphenyl-N,N'-bis(3-methylphenyl)-(1,1'-biphenyl)-4,4'-diamine (TDP); 2,2-bis(4-di-p-tolylaminophenyl)propane; 1,1-bis(4-di-p-tolylaminophenyl)cyclohexane; N,N,N',N'-tetra-p-tolyl-4,4'-diaminobiphenyl; 1,1-bis(4-di-p-tolylaminophenyl)-4-phenylcyclohexane; bis(4-dimethylamino-2-metylphenyl)phenylmethane; bis(4-di-p-tolylaminophenyl)phenylmethane; N,N'-diphenyl-N,N'-di(4-methoxyphenyl)-4,4'-diaminobiphenyl; N,N,N',N'-tetraphenyl-4,4'-diaminodiphenylether; 4,4'-bis(diphenylamino)quadriphenyl; N, N, N-tri(p-tolyl)amine; 4-(di-p-tolylamino)-4'-[4-(di-p-tolylamino)styryl]stilbene; 4-N,N-diphenylamino-(2-diphenylvinyl)benzene; 3-methoxy-4'-N,N-diphenylaminostilbene; and N-phenylcarbazole, in addition thereto, those having two condensed aromatic rings in a molecule described in USP No. 5,061,569, such as 4,4'-bis[N-(1-naphthyl)-N-phenylamino]biphenyl (NDP), and 4,4',4"-tris[N-(3-methylphenyl)-N-phenylamino]triphenylamine (MTDATA), in which three of triphenylamine units are bonded in a star burst form, described in JP-A H04-308688.
A polymer in which the material mentioned above is introduced in the polymer chain or a polymer having the material as the polymer main chain can be also used. As the hole injecting material or the hole transporting material, inorganic compounds such as p-type Si and p- type SiC are usable.
A so-called p-type hole blocking layer as disclosed in JP-A No. 11-251067 or described in the literature of J. Huang et al. (Applied Physics Letters 80(2002), p.139) is also applicable. In the present invention, these materials are preferably utilized since an emitting element exhibiting a higher efficiency is obtained.
This positive hole transport layer can be provided by forming a thin layer made of the above-described positive hole transport material according to a method known in the art such as a vacuum evaporation method, a spin coating method, a cast method, an inkjet method and a LB method. The layer thickness of a positive hole transport layer is not specifically limited, however, is generally 5 nm - 5 $\mu$m, and preferably 5 - 200 nm. This positive transport layer may have a single layer structure comprised of one or two or more types of the above described materials.
A positive hole transport layer having high p-type property doped with impurity can be utilized. Example thereof

includes those described in JP-A-H04-297076, JP-A-2000-196140, JP-A-2001-102175, and J. Appl. Phys., 95, 5773 (2004) and so on.

It is preferable to employ such a positive hole transport layer having high p-type property, since an element with lower power consumption can be prepared in this invention.

<Electron Transport Layer>

An electron transport layer is composed of a material having a function of transporting an electron, and in a broad meaning, an electron transport layer and a positive hole inhibition layer are also included in a positive hole transport layer. A single layer of or plural layers of an electron transport layer may be provided.

The electron transfer material (it works as a positive hole inhibition layer, simultaneously), which is employed in a single electron transfer layer and an electron transfer layer provided adjacent to cathode side with respect to emission layer when it is used as plural layers, is sufficient to have a function to transmit an electron injected from a cathode to an emission layer, and compounds conventionally known in the art can be utilized by arbitrarily selection as a material thereof. Any one can be employed by selecting from conventionally known compounds as its material. Examples of a material include such as a nitro-substituted fluorene derivative, a diphenylquinone derivative, a thiopyrandioxide derivative, a heterocyclic tetracarbonic acid anhydride such as naphthaleneperylene, carbodiimide, a fleorenylidenemethane derivative, anthraquinonedimethane and anthrone derivatives, and an oxadiazole derivative, a carboline derivative, or derivative having a carboline ring structure at least one of carbon atom of hydrocarbon ring of which is substituted by nitrogen atom. Further, a thiazole derivative in which an oxygen atom in the oxadiazole ring of the above-described oxadiazole derivative is substituted by a sulfur atom, and a quinoxaline derivative having a quinoxaline ring which is known as an electron attracting group can be utilized as an electron transfer material. Polymer materials, in which these materials are introduced in a polymer chain or these materials form the main chain of polymer, can be also utilized.

Further, a metal complex of a 8-quinolinol derivative such as tris(8-quinolinol)aluminum (Alq), tris(5,7-dichloro-8-quinolinol)aluminum, tris(5,7-dibromo-8-quinolinol)aluminum, tris(2-methyl-8-quinolinol)aluminum, tris(5-methyl-8-quinolinol)aluminum and bis(8-quinolinol)zinc (Znq); and metal complexes in which a central metal of the aforesaid metal complexes is substituted by In, Mg, Cu, Ca, Sn, Ga or Pb, can be also utilized as an electron transfer material. Further, metal-free or metal phthalocyanine, or those the terminal of which is substituted by an alkyl group and a sulfonic acid group, can be preferably utilized as an electron transfer material. Further, distyrylpyrazine derivative, which has been exemplified as a material of an emission layer, can be also utilized as an electron transfer material, and, similarly to the case of a positive hole injection layer and a positive hole transfer layer, an inorganic semiconductor such as an n-type-Si and an n-type-SiC can be also utilized as an electron transfer material.

This electron transport layer can be provided by forming a thin layer made of the above-described electron transport material according to a method known in the art such as a vacuum evaporation method, a spin coating method, a cast method, an inkjet method and a LB method. The layer thickness of an electron transport layer is not specifically limited; however, is generally 5 nm - 5 μm, preferably 5 - 200 nm. This electron transport layer may have a single layer structure comprised of one or not less than two types of the above described materials.

An electron transport layer having high p-type property doped with impurity can be utilized. Example thereof includes those described in JP-A-H04-297076, JP-A-H10-270172, JP-A-2000-196140, JP-A-2001-102175, and J. Appl. Phys., 95, 5773 (2004) and so on.

It is preferable to employ such an electron transport layer having high p-type property, since an element with lower power consumption can be prepared in this invention.

<Substrate>

A substrate (also referred to as Base Body, Base Plate, Base Material or Support) according to an organic EL element of this invention is not specifically limited with respect to types of such as glass and plastics being transparent or opaque, however, a substrate preferably utilized includes such as glass, quartz and transparent resin film. A specifically preferable substrate is resin film capable of providing an organic EL element with a flexible property.

Resin film includes polyester such as polyethylene terephthalate (PET) and polyethylene naphthalate (PEN), polyethylene, polypropylene, cellophane, cellulose ester and its derivatives such as cellulose diacetate, cellulose triacetate, cellulose acetate butylate, cellulose acetate propionate (CAP), cellulose acetate phthalate (TAC),and cellulose nitrate, polyvinylidene chloride, polyvinylalcohol, polyethylenevinylalcohol, syndiotactic polystyrene, polycarbonate, norbornane resin, polymethylpentene, polyetherketone, polyimide, polyether sulfone (PES), polyphenylene sulfide, polysulfones, polyether imide, polyetherketone imide, polyamide, fluorine resin, nylon, polymethyl methacrylate, acryl or acrylates, cyclo-olefin resin such as ARTON (commercial name, manufactured by JSR Corp.) or APEL (commercial name, manufactured by Mitsui Chemicals Inc.).

On the surface of resin film, an inorganic or organic cover layer or a hybrid cover layer comprising the both

may be formed, and the film is preferably provided with a high barrier ability having a vapor transmittance of not more than 0.01 g/$m^2$·day·atm measured by a method stipulated by JIS K 7129-1992, and more preferably a high barrier ability having an oxygen transmittance of not more than $10^{-3}$ g/$m^2$·day·atm as well as a vapor transmittance of not more than $10^{-3}$ g/$m^2$·day·atm, and further preferably both the vapor transmittance and oxygen transmittance of not more than $10^{-5}$ g/$m^2$·day·atm, measured by a method stipulated by JIS K 7129-1992.

Any materials capable of preventing penetration of substance causing degradation of the element such as moisture and oxygen are usable for forming the barrier layer. For example, silicon oxide, silicon dioxide and silicon nitride are usable. It is more preferable to give a laminated layer structure composed of such the inorganic layer and a layer of an organic material to the barrier layer for improving the fragility of the layer. It is preferable that the both kinds of layers are alternatively piled for several times though there is no limitation as to the laminating order of the inorganic layer and the organic layer.

<<Barrier layer forming method>>

The method for forming the barrier layer is not specifically limited and, for example, a vacuum deposition method, spattering method, reaction spattering method, molecule beam epitaxy method, cluster-ion beam method, ion plating method, plasma polymerization method, atmosphere pressure plasma polymerization method, plasma CVD method, laser CVD method, heat CVD method and coating method are applicable, and the atmosphere pressure plasma polymerization method such as that described in JP A 2004-68143 is particularly preferable.

As the opaque substrate, for example, a plate of metal such as aluminum and stainless steel, a film or plate of opaque resin and a ceramic substrate are cited.

<<Sealing>>

As the sealing means, a method for pasting together with a sealing material, the electrodes and the substrate by an adhesive agent is applicable.

The sealing material is placed so as to cover the displaying area of the organic EL element and may have a flat plate shape or a concave plate shape, and the transparence and the electric insulation property of it are not specifically limited.

Concretely, a glass plate, polymer plate, polymer film, metal plate and metal film can be cited. As the glass plate, a plate of soda-lime glass, barium strontium-containing glass, lead glass, alumino silicate glass, boron silicate glass and quartz are usable. As the polymer plate, a plate of polycarbonate, acryl resin, poly(ethylene terephthalate), polyether sulfide and polysulfone are usable. As the metal plate, a plate composed of one or more kinds of metal selected from stainless steel, iron, copper, aluminum, magnesium, nickel, zinc, chromium, titanium, molybdenum, silicon, germanium and tantalum and an alloy of them are cited.

In the invention, the polymer film and the metal film are preferably used by which the element can be made thinner. The polymer film having an oxygen permeability of not more than $10^{-3}$ g/$m^2$/day and a steam permeability of not more than $10^{-3}$/$m^2$/day is preferred. It is more preferable that the oxygen permeability and the steam permeability are each not more than $10^{-5}$/$m^2$/day, respectively.

For making the sealing material into the concave shape, a sandblast treatment and a chemical etching treatment are applicable. As the adhesive agent, a photo-curable and thermo-curable adhesive agents containing a reactive vinyl group of acryl type oligomer and a methacryl type oligomer, and a moisture curable adhesive agent such as 2-cyanoacrylate can be cited. Epoxy type thermally and chemically (two liquid type) curable adhesive agents are applicable. Hotmelt type polyamide, polyester and polyolefin adhesive agents are applicable. Cationic curable type UV curable epoxy adhesive agent is also usable.

The organic EL element is degraded by heat in some cases, therefore, the adhesive agent capable of being cured to adhere within the temperature range of from room temperature to 80 ° is preferred. A moisture absorbing agent may be dispersed in the adhesive agent. Coating of the adhesive agent onto the adhering portion may be performed by a dispenser available on the market or printing by a screen printing.

It is preferable that an inorganic or organic layer is provided on outside of the electrode placed on the side of facing to the substrate through an organic layer so as to cover the electrode and the organic layer and contact with the substrate to form a sealing layer. In such the case, the material for forming the sealing layer may be a material having a function to inhibit permeation of a substance causing degradation such as water and oxygen, and silicon oxide, silicon dioxide and silicon nitride are usable for example. The layer preferably has a laminated structure composed of an inorganic material and an organic material. As the method for forming such the layer, a vacuum deposition method, spattering method, reaction spattering method, molecule beam epitaxy method, cluster-ion beam method, ion plating method, plasma polymerization method, atmosphere pressure plasma polymerization method, plasma CVD method, laser CVD method, heat CVD method and coating method are applicable.

In the space between the sealing material and the displaying portion of the organic EL element, an inactive gas such as nitrogen and argon or an inactive liquid such as silicone oil is preferably injected. The space may be made vacuum. A moisture absorbing compound may be enclosed in the element.

Examples of the moisture absorbing compound include a metal oxide such as sodium oxide, potassium oxide, calcium oxide, barium oxide, magnesium oxide and aluminum oxide, a sulfate such as sodium sulfate, calcium sulfate, magnesium sulfate and cobalt sulfate, a metal halide such as calcium chloride, magnesium chloride, cesium fluoride, tantalum fluoride, cerium bromide, magnesium bromide, barium iodide and magnesium iodide, and a perchlorate such as barium perchlorate and magnesium perchlorate. Anhydrate is preferable as to the sulfate, halide and perchlorate.

<<Protection layer and protection plate>>

For raising the mechanical strength of the element, a protection layer or a protection plate may be provided on outside of the sealing layer of the side facing to the substrate through the organic layer or the outside of the sealing film. Such the protection layer or plate is preferably provided since the strength of the element is not always so high when the sealing is carried out by the foregoing sealing layer. The glass plate, polymer plate, polymer film and plate, and metal film and plate the same as those to be used for sealing are usable for such the protection material. Polymer film is preferably used from the viewpoint of light weight and thinness.

<Anode>

As an anode according to an organic EL element of this invention, those comprising metal, alloy, a conductive compound, which has a large work function (not less than 4 eV), and a mixture thereof as an electrode substance are preferably utilized. Specific examples of such an electrode substance include a conductive transparent material such as metal like Au, CuI, indium tin oxide (ITO), $SnO_2$ and ZnO. Further, a material such as IDIXO ($In_2O_3$-ZnO), which can prepare an amorphous and transparent electrode, may be also utilized. As for an anode, these electrode substances may be made into a thin layer by a method such as evaporation or spattering and a pattern of a desired form may be formed by means of photolithography, or in the case of requirement of pattern precision is not so severe (not less than 100 μm), a pattern may be formed through a mask of a desired form at the time of evaporation or spattering of the above-described substance. When emission is taken out of this anode, the transmittance is preferably set to not less than 10% and the sheet resistance as an anode is preferably not more than a several hundreds Ω/□. Further, although the layer thickness depends on a material, it is generally selected in a range of 10 - 1,000 nm and preferably of 10 - 200 nm.

<Cathode>

On the other hand, as a cathode according to this invention, metal, alloy, a conductive compound and a mixture thereof, which have a small work function (not more than 4 eV), are utilized as an electrode substance. Specific examples of such an electrode substance includes such as sodium, sodium-potassium alloy, magnesium, lithium, a magnesium/copper mixture, a magnesium/silver mixture, a magnesium/aluminum mixture, a magnesium/indium mixture, an aluminum/aluminum oxide ($Al_2O_3$) mixture, indium, a lithium/aluminum mixture and rare earth metal.

Among them, with respect to an electron injection property and durability against such as oxidation, preferable are a mixture of electron injecting metal with the second metal which is stable metal having a work function larger than electron injecting metal, such as a magnesium/silver mixture, a magnesium/aluminum mixture, a magnesium/indium mixture, an aluminum/aluminum oxide ($Al_2O_3$) mixture and a lithium/aluminum mixture, and aluminum. A cathode can be provided by a method such as evaporation or spattering to form a thin layer. Further, the sheet resistance as a cathode is preferably not more than a several hundreds Ω/□ and the layer thickness is generally selected in a range of 10 - 5 μm and preferably of 50 - 200 nm. Herein, to transmit emission, either one of an anode or a cathode of an organic EL element is preferably transparent or translucent to improve the mission luminance.

A transparent or translucent cathode may be prepared by a method in which the above mentioned metal is provided on the anode with a thickness of 1 - 50 nm and then electroconductive transparent material described as the anode. An element having both transparent anode and cathode may be prepared by applying this method.

<Preparation Method of Organic EL Element>

As an example of a preparation method of an organic EL element of this invention, a preparation method of an organic EL element, comprising anode/positive hole injection layer/positive hole transport layer/emission layer/positive hole inhibition layer/electron transport layer/cathode, will be described.

First, on an appropriate substrate, a thin layer comprising a desired electrode substance such as an anode electrode substance is formed by means of evaporation or spattering so as to make a layer thickness of not more than

1 μm and preferably of 10 - 200 nm, whereby an anode is prepared. Next, thin layers containing organic substances of such as a positive hole injection layer, a positive hole transport layer, an emission layer, a positive hole inhibition layer and an electron transport layer are formed on this layer.

A thin layer forming method of these layers containing the organic substances includes such as an evaporation method and a wet process (a spin coat method, a cast method, an inkjet method, and a printing method) as described before, however, a vacuum evaporation method, a spin coat method, inkjet method, or a printing method is specifically preferable with respect to easy preparation of a homogeneous layer and bare generation of pinholes. Further, a different layer forming method depending on each layer may be applied. In the case of employing an evaporation method in layer formation, the evaporation condition depends on such as the type of a utilized compound, however, is generally appropriately selected in a range of 50 - 450 °C as a boat heating temperature, $10^{-6}$ - $10^{-2}$ Pa as a vacuum degree, 0.01 - 50 nm/sec as a deposition rate, -50 - 300 °C as a substrate temperature and 1 nm - 5 μm, preferably 5 - 200 nm as a layer thickness.

After formation of these layers, a thin layer comprising a cathode electrode substance is formed thereon by means of such as evaporation or spattering so as to make a layer thickness in a range of 50 - 200 nm to provide a cathode, whereby a desired organic EL element can be prepared. This preparation of an organic EL element is preferably carried out with one time evacuation to prepare all through from a positive hole injection layer to a cathode, however, different layer forming method may be also applied by taking out the element on the way. At that time, consideration is necessary such that the operation be performed under a dry inert gas environment.

Further, reversing the preparation order, it is also possible to prepare layers in the order of a cathode, an electron transport layer, a positive hole inhibition layer, an emission layer, a positive hole transport layer and an anode. When a direct current voltage is applied on the multicolor display device thus prepared, emission can be observed by application of a voltage of approximately 2 - 40 V setting an anode to + (plus) polarity and a cathode to - (minus) polarity. Further, no current flows and no emission generate at all even when a voltage is applied with a reversed polarity. Further, in the case of alternate current voltage being applied, emission generates only in a state of an anode being + and a cathode being -. Herein, the wave shape of alternate current may be arbitrary.

Generally it is said that, in the organic EL element of this invention, light is emitted in a layer of which refractive index is higher (the refractive index is about 1.6 to 2.1) than that of air, and only 15 to 20% of the light emitted in the light emission layer can be taken out. This is because the light which enters into the interface (interface of a transparent substrate and air) with the angle θ larger than a critical angle cannot be taken out of the element due to the total internal reflection, or because the light is totally reflected between the transparent substrate and the transparent electrode or between the transparent substrate and the light emission layer, resulting in being wave-guided in the transparent electrode or in the light emission layer to get away to the side of the element.

Examples of a method to improve the efficiency of taking out of the light include: a method to form concavity and convexity on the surface of the transparent substrate to prevent total internal reflection at the interface between the transparent substrate and air (for example, refer to US Patent No. 4,774,435); a method to provide a light converging function to the substrate (for example, refer to JP-A S63-314795); a method to provide a reflecting surface on the side of the element (for example, refer to JP-A No. 1-220394); a method to provide a flat layer between the substrate and the light emission layer, the flat layer having an intermediate refractive index to form an anti-reflection layer (for example, refer to JP-A S62-172691); a method to provide a flat layer having a low refractive index between the substrate and the light emission layer (for example, JP-A 2001-202827); and a method to provide a diffraction grating between any of the substrate, transparent electrode and light emission layer (including the interlayer between the substrate and out side air) (for example refer to JP-A H11-283751).

In the present invention, these methods can be used in combination with the organic electroluminescence element of the present invention. Also, a method of forming a flat layer having a lower refractive index than that of the substrate between the substrate and the light emission layer, or a method of forming a diffraction grating between any of the substrate, transparent electrode and light emission layer (including the interlayer between the substrate and out side air) can be preferably used. In the present invention, by combining these methods, an element exhibiting further higher luminance and durability can be obtained.

When a low refractive index medium having a thickness larger than the wavelength of the light is formed between the transparent electrode and the transparent substrate, the light-extracting efficiency of light which comes out of the transparent electrode increases with decreasing refractive index.

As a low refractive index layer, aerogel, porous silica, magnesium fluoride and fluorine-containing polymer, are cited, for example. Since the refractive index of the transparent substrate is generally 1.5 to 1.7, the refractive index of the low refractive index layer is preferably 1.5 or less and more preferably 1.35 or less.

The thickness of a low refractive index medium is preferably more than twice of the wavelength of the light in the medium, because when the thickness of the low refractive index medium, where the electromagnetic wave exuded as an evanescent wave enters into the transparent substrate, and the effect of the low refractive index layer is reduced.

The method to provide a diffraction grating at the interface where the total internal reflection occurs or in some

of the medium has a feature that the effect of enhancing the light-extracting efficiency is high. The intension of this method is to take out the light which cannot come out due to such as total internal reflection between the layers among the light emitted in the light emission layer, by providing a diffraction grating between any of the layers or in any of the mediums (in the transparent substrate or in the transparent electrode), using the property of the diffraction grating that it can change the direction of light to a specified direction different from the direction of reflection due to so-called Bragg diffraction such as primary diffraction or secondary diffraction.

The diffraction grating to be provided preferably has a two-dimensional periodic refractive index. This is because, since the light is emitted randomly to any direction, only the light proceeds to a specific direction can be diffracted when a generally used one-dimensional diffraction grating having a periodic refractive index only in a specific direction is used, whereby the light-extracting efficiency is not largely increases. However, by using diffraction grating having a two-dimensionally periodic refractive index, the light proceeds any direction can be diffracted, whereby the light-extracting efficiency is increased.

The diffraction grating may be provided between any of the layers on in any of the mediums (in the transparent substrate or in the transparent electrode), however, it is preferably provided in the vicinity of the organic light emission layer where the light is emitted.

The period of the diffraction grating is preferably 1/2 to 3 times of the wavelength of the light in the medium. The array of the diffraction grating is preferably two-dimensionally repeated, for example, as in the shape of a square lattice, a triangular lattice, or a honeycomb lattice.

In the organic electroluminescence element of the present invention, the luminance in the specified direction, for example, the front direction against the emitting plane of the element can be increased, for example, by processing to form a structure of a micro-lens array or in combination with a so-called light-condensing sheet on the light-extracting side surface of the substrate.

As an example of a micro-lens array, quadrangular pyramids 30 μm on a side and having a vertex angle of 90° are two-dimensionally arranged on the light extracting side surface of the substrate. The side of the quadrangular pyramids is preferably 10 - 100 μm. When the length of the side is shorter than the above range, the light is colored due to the effect of diffraction, and when it is longer than the above range, it becomes unfavorably thick.

As a light-condensing sheet, the one practically applied for an LED backlight of a liquid crystal display is applicable. Examples of such a sheet include a brightness enhancing film (BEF) produced by SUMITOMO 3M Inc. As the shape of the prism, triangle-shaped strip having a vertex angle of 90° and a pitch of 50 μm, the one having round apexes, or the one having a randomly changed pitch may be included.

In order to control the luminous radiation angle of the light emitting element, a light diffusion plate and a film may be used in combination with the light-condensing sheet. For example, a diffusion film (light-up) produced by KIMOTO Co., Ltd. can be used.

<<Use>>

The organic EL element of the invention can be used as a displaying device, display, and various kinds of light source. As the light source, domestic illumination, car interior illumination, backlight of watches or liquid crystal displays, sign boards, signals, light source of photo memories, light source of electrophotographic copying machine, light source of light communication processor and light source of light sensors though the use is not limited to the above. Particularly, the device is suitably used in combination with a color filter as the backlight of the liquid crystal display or the light source of illumination.

When the device combined with a color filter is used as the backlight of the display, the device is preferably used in combination with a light collection sheet for further raising illuminance.

## EXAMPLES

The invention will be described by Examples, to which this invention is not restricted.

<<Preparation of Organic EL element 1>>

For preparing an anode, an electrode was patterned on a glass substrate having a size of 30 mm x 30 mm and a thickness of 0.7 mm and an ITO (indium tin oxide) layer of 120 nm formed thereon and the transparent substrate having the ITO transparent electrode was washed by isopropyl alcohol while applying ultrasonic wave, dried by desiccated nitrogen gas and subjected to UV-ozone washing. Then the transparent substrate was fixed on the substrate holder of a vacuum deposition apparatus available on the market.

Suitable amount of constitution materials of each of the layers were separately charged in each of crucibles, respectively. The crucibles made from a heat resistive material prepared by molybdenum or tungsten was used.

Then the pressure in the vacuum deposition apparatus was reduced by a vacuum degree of 4 x $10^{-4}$ Pa and the crucible containing m-MTDATA was heated by applying electric current for depositing m-MTDATA onto the transparent substrate at a deposition rate of 0.1 nm/sec to form a positive hole injection layer of 20 nm. Next, $\alpha$-NPD was deposited in the similar manner to form a positive hole transfer layer of 40 nm. After that, each of the light emission layers and intermediate layer were formed by the following procedure.
Compound A-2 and Compound Ir-12 were co-deposited at a deposition rate of 0.1 nm/sec so as to make the thickness ratio of 95:5 to form a blue phosphorescent light emission layer of 12 nm and then Compound A-3 was deposited at a deposition rate of 0.1 nm/sec to form a positive hole blocking layer of 3 nm adjacent on the cathode side of the blue light emission layer.
Compound A-1 and Compound Ir-14 were co-deposited at a deposition rate of 0.1 nm/sec so as to make the thickness ratio of 92:8 to form a red phosphorescent light emission layer of 10 nm and then Compound A-1 was deposited at a deposition rate of 0.1 nm/sec to form a layer of 3 nm.
Compound A-1 and Compound Ir-1 were co-deposited at a deposition rate of 0.1 nm/sec so as to make the thickness ratio of 96:4 to form a green phosphorescent light emission layer of 2.5 nm. After that, the crucible containing BAlq was heated by applying electric current and Balq was deposited on the above layer at a deposition rate of 0.1 nm/sec to form a positive hole blocking layer of 5 nm, and then BCP and CsF were co-deposited at a deposition rate of 0.1 nm/sec so as to make the thickness ratio of 3:1 to provide an electron transfer layer of 40 nm.
Moreover, an aluminum layer of 110 nm was deposited to form a cathode. Thus Organic EL element 1 was prepared. The wavelength of the maximum light emission of the phosphorescent used in the blue light emission layer was 459 nm and the ionization potential energy of it was 5.8 eV and that of the light emission dopant Ir-1 was 5.5 eV.

<<Preparation of Organic EL element 2>>

Organic EL element 2 was prepared in the same manner as in Organic EL element 1 except that an intermediate layer of 3 nm formed by depositing Compound A-1 at a deposition rate of 0.1 nm/sec was provided in place of the positive hole blocking layer adjacent to the cathode side of the blue light emission layer.

<<Preparation of Organic EL element 3>>

The pressured in the apparatus was reduced by a vacuum degree of 4 x $10^{-4}$ Pa and the crucible containing m-MTDATA was heated by applying electric current so as to form a positive hole injection layer of 20 nm at a depositing rate of 0.1 nm/sec on the substrate the same as that used in Organic EL element 1, and then $\alpha$-NPD was vapor deposited to provide a positive hole transfer layer of 40 nm. After that, each of the light emission layers and the intermediate layers were provided by the following procedures.
Compound A-2 and Compound D-1 were co-deposited at a deposition rate of 0.1 nm/sec so as to make the thickness ratio of 95:5 to form a blue phosphorescent light emission layer of 12 nm and then Compound A-1 was deposited at a deposition rate of 0.1 nm/sec to form an intermediate layer.
Compound A-2 and Compound Ir-14 were co-deposited at a deposition rate of 0.1 nm/sec so as to make the thickness ratio of 92:8 to form a red phosphorescent light emission layer of 10 nm. After that, Compound A-1 was vapor deposited at a deposition rate of 0.1 nm/sec to form a layer of 2.5 nm.
Compound A-1 and Compound Ir-1 were co-deposited at a deposition rate of 0.1 nm/sec so as to make the thickness ratio of 96:4 to form a green phosphorescent light emission layer of 2.5 nm.
After that, the crucible containing BAlq was heated by applying electric current to form a positive hole blocking layer of 5 nm on the above layer, and then BCP and CsF were co-deposited in a layer thickness of 3:1 at a deposition rate of 0.1 nm to form an electric transfer layer of 40 nm.
Furthermore, an aluminum layer of 110 nm was vapor deposited to form a cathode. Thus Organic EL element 3 was prepared. The emission maximum wavelength of the phosphorescent dopant used in the blue light emission layer was 470 nm and the ionization potential energy of it was 5.0 eV and that of the light emission dopant was lower than that of Ir-1.

<<Preparation of Organic EL element 4>>

Organic EL element 4 was prepared in the same manner as in Organic EL element 3 except that Compound D-43 was used in place of Compound D-1. The wavelength of the light emitted from Compound D-43 was within the range of the invention and the ionization potential energy of that was lower than 5.1 eV.

m－MTDATA

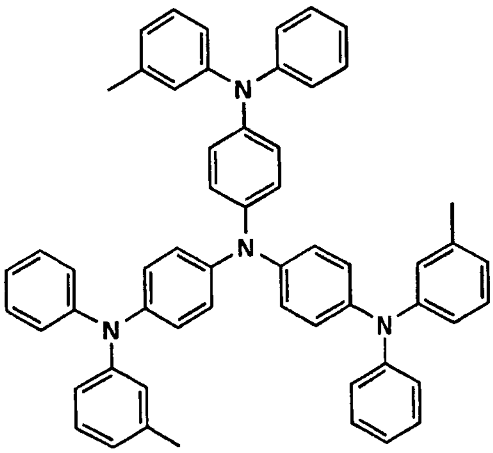

BAlq

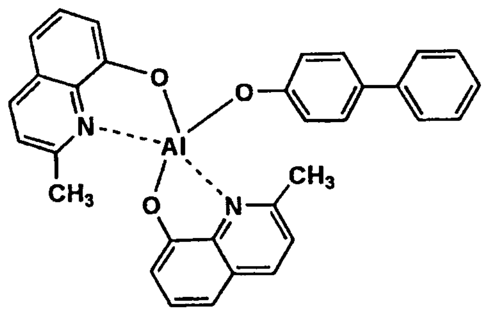

α－NPD

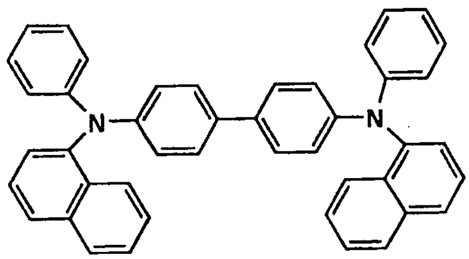

BCP

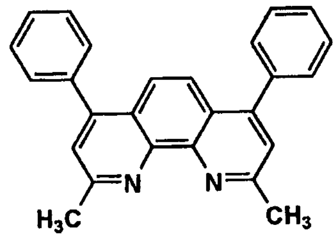

A－1

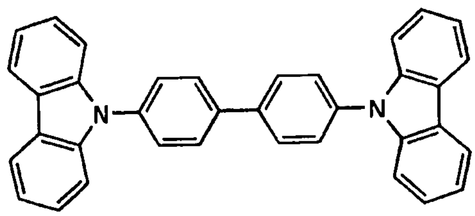

A－2

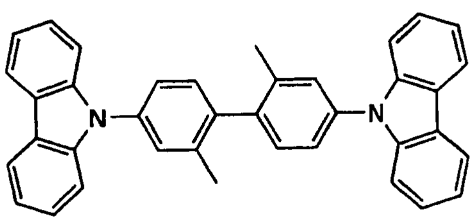

A－3

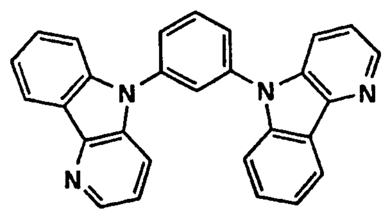

<<Sealing treatment, evaluation of electric power efficiency and driving voltage of organic EL element>>

The non-light emission face of each of Organic EL elements 1 to 4 was covered by a glass case to prepare an illuminating device such as that shown in Figs. 1 and 2. The sealing treatment using the glass case was carried out in a glove box filled by highly purified nitrogen having a purity of 99.999% so that the organic EL element is not exposed to air. The electric power efficiency and chromaticness of the devices were evaluated by using a spectral radiation luminance meter CS-1000 manufactured by Konica Minolta Sensing Inc. The evaluation results are listed in Table 1. In Table 1, the electric power efficiency is represented by a relative value when the electric efficiency of Organic EL element 1 at a luminance of 800 cd/$m^2$ is set at 1.

Table 1

| Organic EL element No. | Layer order in light emission unit (from anode side) | Electric power efficiency | Emitted light color |
|---|---|---|---|
| 1. (Comp.) | Blue/Positive hole blocking layer/Green/ Intermediate layer/Red | 100 | White |
| 2. (Comp.) | Blue/Positive hole blocking layer/Green/ Intermediate layer/Red | 110 | Orange-red |
| 3. (Inv.) | Blue/Intermediate layer/Green/ Intermediate layer/Red | 115 | White |
| 4. (Inv.) | Blue/Intermediate layer/Green/ Intermediate layer/Red | 110 | White |
| (Comp.): (Comparative) (Inv.): (Inventive) | | | |

Color of the light emitted by Organic EL elements 1, 3 and 4 was almost white and that emitted from Organic EL element 2 was orange-red and white light was not obtained. Organic EL elements 3 and 4 were superior to Organic EL element 1 in the electric power efficiency. The organic EL elements of the invention showed suitable properties when the devices were used for the backlight of liquid crystal displays.

**Claims**

1. An electroluminescent element having three or more light emission layers each containing a dopant and emitting a light having a different wave length from each other in which at least one layer contains a phosphorescent dopant which emits a light having an emission maximum wavelength of from 440 to 490 nm in a solid state, wherein tan ionization potential energy of the phosphorescent dopant is not higher than 5.1 eV and is lower than that of at least one of other light emission dopants.

2. The organic electroluminescent element described in claim 1, wherein the phosphorescent dopant emitting a light having the emission maximum wavelength of from 440 to 490 nm has a partial structure selected from Formulas A to C,

Formula A

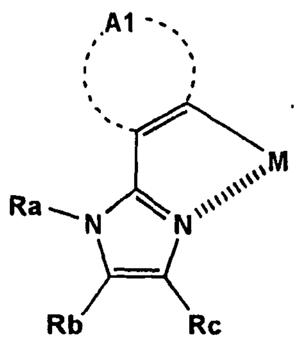

wherein Ra is a hydrogen atom, an aliphatic group, an aromatic group or a heterocyclic group, Rb and Rc are each a hydrogen atom or a substituent, A1 is a residue necessary for forming an aromatic group or a heterocyclic group and M is Ir or Pt,

Formula B

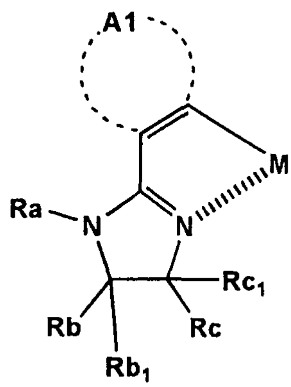

wherein Ra is a hydrogen atom, an aliphatic group, an aromatic group or a heterocyclic group, Rb, Rc, $Rb_1$ and $Rc_1$ are each a hydrogen atom or a substituent, A1 is a residue necessary for forming an aromatic group or a heterocyclic group and M is Ir or Pt,

Formula C

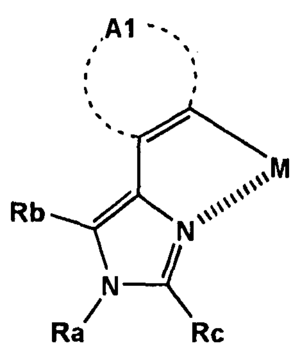

in the formula, Ra is a hydrogen atom, an aliphatic group, an aromatic group or a heterocyclic group, Rb and Rc are each a hydrogen atom or a substituent, A1 is a residue necessary for forming an aromatic group or a heterocyclic group and M is Ir or Pt.

**3.** A liquid crystal display which has the organic electroluminescent element described in claim 1 or 2 as a backlight.

**4.** An illuminating device which has an organic electroluminescent element described in claim 1 or 2 as a light source.

FIG. 1

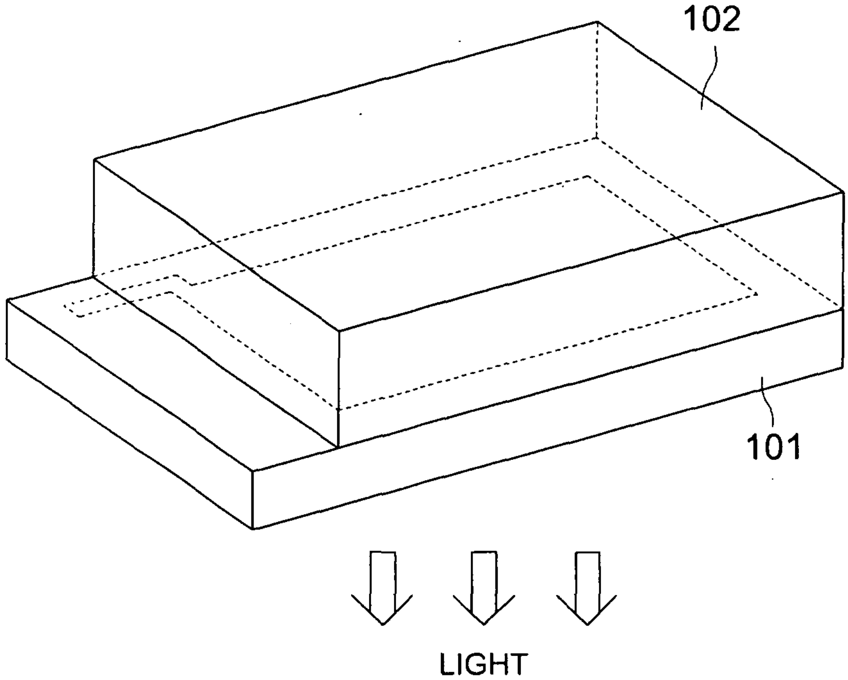


FIG. 2

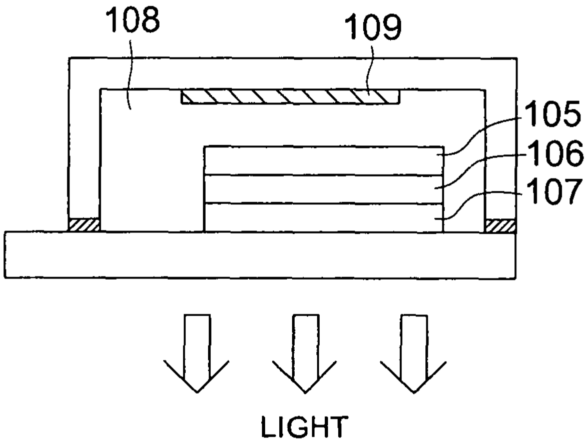

**INTERNATIONAL SEARCH REPORT**

International application No.
PCT/JP2006/318905

A. CLASSIFICATION OF SUBJECT MATTER
*H01L51/50*(2006.01)i, *C09K11/06*(2006.01)i, *G02F1/13357*(2006.01)i

According to International Patent Classification (IPC) or to both national classification and IPC

B. FIELDS SEARCHED

Minimum documentation searched (classification system followed by classification symbols)
H01L51/50, C09K11/06, G02F1/13357

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)
STN(CAplus)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2004-522276 A (The Trustees of Princeton University),<br>22 July, 2004 (22.07.04),<br>Par. Nos. [0017] to [0080]; Figs. 1, 9<br>& US 2002/0197511 A1 & EP 1390962 A2<br>& KR 2004012843 A & WO 2002/91814 A2<br>& AU 2002305548 A1 & CN 1543659 A<br>& IN 200301950 P1 | 1,3-4<br>2 |
| Y | JP 2005-53912 A (Samsung SDI Co., Ltd.),<br>03 March, 2005 (03.03.05),<br>Par. Nos. [0018], [0054]<br>& US 2005/0031903 A1 & KR 2005015811 A<br>& CN 1626540 A & KR 2005082059 A | 2 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>12 October, 2006 (12.10.06) | Date of mailing of the international search report<br>24 October, 2006 (24.10.06) |
| Name and mailing address of the ISA/<br>Japanese Patent Office<br>Facsimile No. | Authorized officer<br><br>Telephone No. |

Form PCT/ISA/210 (second sheet) (April 2005)

**INTERNATIONAL SEARCH REPORT**

International application No.
PCT/JP2006/318905

C (Continuation). DOCUMENTS CONSIDERED TO BE RELEVANT

| Category* | Citation of document, with indication, where appropriate, of the relevant passages | Relevant to claim No. |
|---|---|---|
| A | JP 2003-282266 A (Matsushita Electric Works, Ltd.), 03 October, 2003 (03.10.03), Full text; all drawings (Family: none) | 1-4 |
| A | JP 2005-100921 A (Sony Corp.), 14 April, 2005 (14.04.05), Figs. 4, 6 & WO 2005/027586 A1 & EP 1667694 A1 | 1-4 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP H06207170 A
- JP 2004235168 A
- US 6097147 A
- JP 2003282265 A
- WO 0527586 A
- JP 2001257076 A
- JP 2002308855 A
- JP 2001313179 A
- JP 2002319491 A
- JP 2001357977 A
- JP 2002334786 A
- JP 2002008860 A
- JP 2002334787 A
- JP 2002015871 A
- JP 2002334788 A
- JP 2002043056 A
- JP 2002334789 A
- JP 2002075645 A
- JP 2002338579 A
- JP 2002105445 A
- JP 2002343568 A
- JP 2002141173 A
- JP 2002352957 A
- JP 2002203683 A
- JP 2002363227 A
- JP 2002231453 A
- JP 2003003165 A
- JP 2002234888 A
- JP 2003027048 A
- JP 2002255934 A
- JP 2002260861 A
- JP 2002280183 A
- JP 2002299060 A
- JP 2002302516 A
- JP 2002305083 A
- JP 2002305084 A
- JP 2002308837 A
- WO 0070655 A
- JP 2002280178 A
- JP 2001181616 A
- JP 2002280179 A
- JP 2001181617 A
- JP 2002280180 A
- JP 2001247859 A
- JP 2001313178 A
- JP 2002302671 A
- JP 2001345183 A
- JP 2002324679 A
- WO 0215645 A
- JP 2002332291 A
- JP 2002050484 A
- JP 2002332292 A
- JP 2002083684 A
- JP 2002540572 A
- JP 2002117978 A
- JP 2002338588 A
- JP 2002170684 A
- JP 2002352960 A
- WO 0193642 A
- JP 2002050483 A
- JP 2002100476 A
- JP 2002173674 A
- JP 2002359082 A
- JP 2002175884 A
- JP 2002363552 A
- JP 2002184582 A
- JP 2003007469 A
- JP 2002525808 A
- JP 2003007471 A
- JP 2002525833 A
- JP 2003031366 A
- JP 2002226495 A
- JP 2002234894 A
- JP 2002235076 A
- JP 2002241751 A
- JP 2001319779 A
- JP 2001319780 A
- JP 2002062824 A
- JP 2002100474 A
- JP 2002203679 A
- JP 2002343572 A
- JP 2002203678 A
- JP H0945479 A
- JP H09260062 A
- JP H08288069 A
- JP H06325871 A
- JP H0917574 A
- JP H1074586 A
- JP H11204258 A
- JP H11209359 A
- US 5061569 A
- JP H04308688 A
- JP 11251067 A
- JP H04297076 A
- JP 2000196140 A
- JP 2001102175 A
- JP H10270172 A
- JP 2004068143 A

- US 4774435 A
- JP S63314795 A
- JP 1220394 A
- JP S62172691 A
- JP 2001202827 A
- JP H11283751 A


**Non-patent literature cited in the description**


- **M. A. BALDO et al.** *Nature,* 1998, vol. 395, 151-154
- **M. A. BALDO et al.** *Nature,* 2000, vol. 403, 750-753
- **B. W. D'ANDRADE et al.** *Advanced Materials,* 2002, vol. 14, 147-151
- New Edited Coloring Science Handbook. University of Tokyo Press, 1985
- **BUNKO II.** Jikken Kagaku Koza 7. Maruzen, 1992, vol. 7, 398
- *Inorg. Chem.,* vol. 40, 1704-1711
- Organic EL Elements and Industrialization. N. T. S. Inc, 30 November 1998, vol. 2, 123-166
- Organic EL Elements and Industrialization. NTS. Inc, 30 November 1998, 273
- **J. HUANG et al.** *Applied Physics Letters,* 2002, vol. 80, 139
- *J. Appl. Phys.,* 2004, vol. 95, 5773